# EUROPEAN PATENT APPLICATION

(11) **EP 4 794 486 A1**
(43) Date of publication of application: **19.08.2026**
(21) Application number: 26156956.0
(22) Date of filing: 06.02.2026
(51) Int. Cl.: H10F 39/18, H10F 39/00

(54) **IMAGE SENSOR INCLUDING NANO-PHOTONIC LENS ARRAY AND ELECTRONIC DEVICE INCLUDING THE IMAGE SENSOR**

(30) Priority: 18.02.2025 KR 20250020967
(71) Applicant: Samsung Electronics Co., Ltd., Suwon-si, Gyeonggi-do 16677 (KR)
(72) Inventor: ROH, Sookyoung, 16678 Suwon-si (KR); SONG, Subeom, 16678 Suwon-si (KR); YUN, Seokho, 16678 Suwon-si (KR)
(74) Representative: Elkington and Fife LLP

(57) **Abstract**

An image sensor includes a sensor substrate including a first pixel, a second pixel, a third pixel, and a fourth pixel, and a nano-photonic lens array including a first meta-region, a second meta-region, a third meta-region, and a fourth meta-region, wherein each of the first to fourth meta-regions includes at least one nano-structure configured to condense light of a first wavelength onto the first and fourth pixels, light of a second wavelength onto the second pixel, and light of a third wavelength onto the third pixel, and at least one nano-structure provided in at least one of the second meta-region and the third meta-region is a polarization-separating nano-structure configured to provide the light of the first wavelength having a first polarization component to the first pixel and provide the light of the first wavelength having a second polarization component to the fourth pixel.

## Description

### FIELD OF THE INVENTION

The disclosure relates to an image sensor including a nano-photonic lens array and an electronic device including the image sensor.

### BACKGROUND OF THE INVENTION

Image sensors generally sense the color of incident light by using a color filter. However, a color filter may have low light utilization efficiency because the color filter absorbs light of colors other than the corresponding color of incident light. For example, in the case in which a red-green-blue (RGB) color filter is used, only 1/3 of incident light is transmitted therethrough and the other part of the incident light, that is, 2/3 of the incident light, is absorbed. Thus, light utilization efficiency is only about 33%. Most of light loss in the image sensor occurs in a color filter. Accordingly, a method of separating colors by using each pixel in an image sensor without using a color filter has been attempted.

### SUMMARY OF THE INVENTION

Provided is an image sensor including a nano-photonic lens array having both a color separating characteristic and a polarization-separating characteristic.

Additional aspects will be set forth in part in the description which follows and, in part, will be apparent from the description, or may be learned by practice of the presented embodiments of the disclosure.

An image sensor according to an embodiment includes a sensor substrate including a plurality of unit pixel groups, each of the plurality of unit pixel groups including a first pixel, a second pixel, a third pixel, and a fourth pixel, and a nano-photonic lens array including a plurality of unit meta-groups, each of the plurality of unit meta-groups including a first meta-region corresponding to the first pixel, a second meta-region corresponding to the second pixel, a third meta-region corresponding to the third pixel, and a fourth meta-region corresponding to the fourth pixel, wherein each of the first to fourth meta-regions includes at least one nano-structure configured to condense, from among incident light on the nano-photonic lens array, light of a first wavelength onto the first pixel and the fourth pixel, light of a second wavelength different from the first wavelength onto the second pixel, and light of a third wavelength different from the first and second wavelengths onto the third pixel, and at least one nano-structure provided in at least one of the second meta-region and the third meta-region is a polarization-separating nano-structure configured to provide the light of the first wavelength having a first polarization component to the first pixel and provide the light of the first wavelength having a second polarization component to the fourth pixel.The specification concerns an image sensor architecture in which colour separation and focusing are performed by a nano-photonic lens array rather than by conventional absorption-based colour filters. Each unit pixel group may comprise four pixels arranged in a 2×2 block, each being aligned with a corresponding unit "meta-group" of nanostructured meta-regions. It is proposed to combine wavelength-selective phase modulation with in-plane polarization separation, achieved by tailored nano-structures within selected meta-regions. This may enable simultaneous colour and polarization discrimination at each pixel, significantly increasing light utilisation and allowing richer scene analysis.

A core structure is a nano-photonic lens array comprising sub-wavelength dielectric nano-structures arranged to impart position-dependent phase delays that steer specific wavelength bands to designated pixels. The array directs a first wavelength (e.g., green or yellow) onto two diagonally opposed pixels, a second wavelength (e.g., red/magenta) to one pixel, and a third wavelength (e.g., blue/cyan) to another. At least one nano-structure in the second and/or third meta-regions may be engineered as a polarization-separating structure - typically a cross-shaped or multi-arm geometry with anisotropic lengths and widths. This induces directional resonance for orthogonal linear polarization states, enabling one polarization component of the first wavelength to be directed to the first pixel and the orthogonal component to the fourth pixel. Variants include integrated cross structures, disjoint arms, multi-element arrangements, and sub-nano-structures placed symmetrically around the principal element to enhance polarization selectivity.

Embodiments may provide both spectral separation and polarization separation without absorption losses characteristic of colour filters. Phase control derives from refractive-index contrast and nanostructure geometry (diameter/width, height, and spatial pattern). Polarization separation can be produced by resonant anisotropy within the cross-type nano-structures, the relative lengths/widths determining the resonance direction. Technical advantages may include substantially increased quantum efficiency across all wavelengths, improved SNR under low-light conditions, and the ability to extract polarization-resolved information for material classification, reflection suppression, and texture analysis. Simulation and test data within the specification demonstrate directional routing of orthogonal polarization components and corresponding pixel-wise QE asymmetries.

It is further proposed to integrate embodiments with a colour-filter layer, a dedicated polarization-separating layer employing wire-grid polarizers, and sub-pixel architectures allowing per-sub-pixel polarization discrimination across multiple axes (0°, 90°, 45°, 135°). This enhances flexibility in system integration: the nano-photonic lens array alone provides high efficiency colour-polarization separation, while the additional layers permit more complex multi-polarization capture modes or higher colour purity where required. Manufacturing considerations are addressed through the use of spacer layers to flatten underlying surfaces, etch-stop layers to protect intermediate layers, and materials compatible with low-absorption operation in the visible regime.

At system level, an image sensor according to a proposed embodiment may be readily incorporated into single- or multi-camera modules, including folded-optics configurations. Improved low-light performance and polarization-resolved capture can be exploited by downstream image signal processors for autofocus, HDR fusion, reflection removal, depth estimation, and multi-camera synthesis. Embodiments may thus provide an integrated nano-optical front-end that enhances both radiometric and polarimetric information capture without sacrificing fill-factor or quantum efficiency.

The polarization-separating nano-structure may include a first extension portion extending in a first direction and a second extension portion extending in a second direction crossing the first direction, the first extension portion may have a first length in the first direction and a first width in the second direction and the second extension portion has a second length in the second direction and a second width in the first direction, and the first length may be greater than the first width and the second length may be greater than the second width.

The first length and the second length may be equal to each other and the first width and the second width are equal to each other.

The polarization-separating nano-structure may be configured so that the first extension portion and the second extension portion cross each other at centers thereof.

The first extension portion and the second extension portion extend integrally with each other at a contact cross point.

The second meta-region may include a first polarization-separating nano-structure configured to transmit, in light incident on the second meta-region, the light of the first wavelength having the first polarization component to the first pixel in the first direction and the light of the first wavelength having the second polarization component to the fourth pixel in the second direction, and the third meta-region may include a second polarization-separating nano-structure configured to transmit, in light incident on the third meta-region, the light of the first wavelength having the first polarization component to the first pixel in the second direction and the light of the first wavelength having the second polarization component to the fourth pixel in the first direction.

The first polarization-separating nano-structure and the second polarization-separating nano-structure may be different from each other in at least one of the first length of the first extension portion, the first width of the first extension portion, the second length of the second extension portion, and the second width of the second extension portion.

The first length of the first extension portion and the second length of the second extension portion may be less than a size of the second meta-region or the third meta-region in which the polarization-separating nano-structure is provided.

The first length of the first extension portion may be equal to a width of the second meta-region or the third meta-region, in which the polarization-separating nano-structure is provided, in the first direction, or the second length of the second extension portion may be equal to a width of the second meta-region or the third meta-region, in which the polarization-separating nano-structure is provided, in the second direction.

The second meta-region or the third meta-region may further include a plurality of polarization-separating sub-nano-structures that are symmetrically provided around the polarization-separating nano-structure, and each of the plurality of polarization-separating sub-nano structures may have a shape in which one end of the first extension portion in the first direction and one end of the second extension portion in the second direction are integrally connected at an angle of 90-degree.

The polarization-separating nano-structure may include a plurality of first extension portions extending in a first direction and a plurality of second extension portions extending in a second direction crossing the first direction, each of the plurality of first extension portions may have a first length in the first direction and a first width in the second direction and each of the plurality of second extension portions may have a second length in the second direction and a second width in the first direction, and the first length may be greater than the first width and the second length is greater than the second width.

The plurality of first extension portions may be spaced apart from one another and arranged in a row in the first direction, and the plurality of second extension portions may be spaced apart from one another and arranged in a row in the second direction.

The polarization-separating nano-structure may include two first extension portions and two second extension portions, end portions facing each other in the two first extension portions may be spaced apart a same distance from the center of the second meta-region or the third meta-region, in which the polarization-separating nano-structure is provided, in the first direction, and end portions facing each other in the two second extension portions may be spaced apart a same distance from the center of the second meta-region or the third meta-region, in which the polarization-separating nano-structure is provided, in the second direction.

The plurality of first extension portions and the plurality of second extension portions may be arranged so that a line segment in the first direction for connecting centers of the plurality of first extension portions and a line segment in the second direction for connecting centers of the plurality of second extension portions may cross each other at the center of the second meta-region or the third meta-region, in which the polarization-separating nano-structure is provided.

Each of the plurality of first extension portions and each of the plurality of second extension portions may have rectangular shapes.

The image sensor may further include a polarization-separating layer provided between the sensor substrate and the nano-photonic lens array, wherein the polarization-separating layer may include a plurality of unit polarization-separating groups each including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region, the first polarization-separating region may include a first polarizer that transmits the light of the first polarization component and reflects or absorbs the light of the second polarization component, and the fourth polarization-separating region may include a second polarizer that transmits the light of the second polarization component and reflects or absorbs the light of the first polarization component, and the second polarization-separating region and the third polarization-separating region may be filled with a material having transmittance with respect to visible light.

The first pixel, the second pixel, the third pixel, and the fourth pixel may each include a first sub-pixel, a second sub-pixel, a third sub-pixel, and a fourth sub-pixel that are grouped and arranged two-dimensionally.

The image sensor may include a polarization-separating layer provided between the sensor substrate and the nano-photonic lens array, wherein the polarization-separating layer may include a plurality of unit polarization-separating groups each including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region, the first polarization-separating region may include a first polarizer that transmits the light of the first polarization component and reflects or absorbs the light of the second polarization component, and the fourth polarization-separating region includes a second polarizer that transmits the light of the second polarization component and reflects or absorbs the light of the first polarization component, and the second polarization-separating region and the third polarization-separating region may each include the first polarizer, the second polarizer, a third polarizer transmitting light having a third polarization component that is in a different direction from the first polarization component and the second polarization component, and a fourth polarizer transmitting light having a fourth polarization component that is in a different direction from the first to third polarization components, the first polarizer, the second polarizer, the third polarizer, and the fourth polarizer of the second polarization-separating region may be each provided to face one of the first to fourth sub-pixels of the second pixel, and the first polarizer, the second polarizer, the third polarizer, and the fourth polarizer of the third polarization-separating region may be each provided to face one of the first to fourth sub-pixels of the third pixel.

The image sensor may further include a polarization-separating layer provided between the sensor substrate and the nano-photonic lens array, wherein the polarization-separating layer may include a plurality of unit polarization-separating groups each including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region, the first polarization-separating region may include two first polarizers transmitting the light of the first polarization component and reflecting or absorbing the light of the second polarization component, the fourth polarization-separating region may include two second polarizers transmitting the light of the second polarization component and reflecting or absorbing the light of the first polarization component, the first polarization-separating region may further include two third polarizers transmitting light having a third polarization component that is in a different direction from the first polarization component and the second polarization component, the fourth polarization-separating region may further include two fourth polarizers transmitting light having a fourth polarization component that is in a different direction from the first to third polarization components, the second polarization-separating region and the third polarization-separating region may each include the first polarizer, the second polarizer, the third polarizer, and the fourth polarizer, the first polarizer, the second polarizer, the third polarizer, and the fourth polarizer of the second polarization-separating region may be each provided to face one of the first to fourth sub-pixels of the second pixel, and the first polarizer, the second polarizer, the third polarizer, and the fourth polarizer of the third polarization-separating region may be each provided to face one of the first to fourth sub-pixels of the third pixel.

An electronic device according to an embodiment includes a lens assembly configured to form an optical image of a subject, an image sensor configured to convert the optical image formed by the lens assembly into an electrical signal, and a processor configured to process the electrical signal generated by the image sensor, wherein the image sensor includes a sensor substrate including a plurality of unit pixel groups, each of the plurality of unit pixel groups including a first pixel, a second pixel, a third pixel, and a fourth pixel, and a nano-photonic lens array including a plurality of unit meta-groups, each of the plurality of unit meta-groups including a first meta-region corresponding to the first pixel, a second meta-region corresponding to the second pixel, a third meta-region corresponding to the third pixel, and a fourth meta-region corresponding to the fourth pixel,wherein each of the first to fourth meta-regions includes at least one nano-structure configured to condense, from among incident light incident on the nano-photonic lens array, light of a first wavelength onto the first pixel and the fourth pixel, light of a second wavelength different from the first wavelength onto the second pixel, and light of a third wavelength different from the first and second wavelengths onto the third pixel, and at least one nano-structure provided in at least one of the second meta-region and the third meta-region is a polarization-separating nano-structure configured to provide the light of the first wavelength having a first polarization component to the first pixel and provide the light of the first wavelength having a second polarization component to the fourth pixel.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic block diagram of an image sensor according to an embodiment;
FIGS. 2A and 2B are cross-sectional views schematically showing a configuration of a pixel array in an image sensor according to an embodiment;
FIG. 3 shows an example of a pixel arrangement in a sensor substrate according to an embodiment;
FIG. 4 shows an example of an arrangement of meta-regions in a nano-photonic lens array according to an embodiment;
FIG. 5 shows an example of phase profiles of green light and red light after passing through a nano-photonic lens array.
FIG. 6 shows an example of phase profiles of blue light and green light after passing through the nano-photonic lens array;
FIG. 7 shows an example of an arrangement of a plurality of nano-structures in a unit meta-group in a nano-photonic lens array according to an embodiment;
FIGS. 8 and 9 show examples of an operation of a polarization-separating nano-structure;
FIG. 10 shows an example of a unit meta-group in a nano-photonic lens array for a test in order to check only a polarization-separating characteristic due to a polarization-separating nano-structure;
FIG. 11 shows an example of a distribution of light having a first polarization component in green light that passed through the nano-photonic lens array for the test shown in FIG. 10 in cross-sections of a first meta-region and a second meta-region;
FIG. 12 shows an example of a distribution of light having a second polarization component in green light that passed through the nano-photonic lens array for test shown in FIG. 10 in cross-sections of a first meta-region and a second meta-region;
FIG. 13 is a graph showing an example of a quantum efficiency with respect to light having a first polarization component in an image sensor including the nano-photonic lens array for the test shown in FIG. 10;
FIG. 14 is a graph showing an example of a quantum efficiency with respect to light having a second polarization component in an image sensor including the nano-photonic lens array for the test shown in FIG. 10;
FIG. 15 is a graph showing an example of a quantum efficiency with respect to light having a first polarization component in an image sensor in which the nano-photonic lens array for the test shown in FIG. 10 and a color filter are combined;
FIGS. 16A to 16F show examples of arrangements of a plurality of nano-structures in a unit meta-group in a nano-photonic lens array according to some embodiments;
FIGS. 17A and 17B are cross-sectional views schematically showing a structure of a pixel array in an image sensor according to another embodiment;
FIG. 18 shows an example of a color filter arrangement in a color filter layer according to an embodiment;
FIGS. 19A and 19B are cross-sectional views schematically showing a structure of a pixel array in an image sensor according to another embodiment;
FIG. 20 shows an example of an arrangement of polarization-separating regions in a polarization-separating layer according to an embodiment;
FIGS. 21A and 21B are cross-sectional views schematically showing a structure of a pixel array in an image sensor according to another embodiment;
FIGS. 22A and 22B are cross-sectional views schematically showing a structure of a pixel array in an image sensor according to another embodiment;
FIG. 23 shows an example of a pixel arrangement in a sensor substrate shown in FIGS. 22A and 22B;
FIGS. 24A and 24B show examples of arrangement of unit polarization-separating group in a polarization-separating layer according to some embodiments;
FIGS. 25A and 25B are cross-sectional views schematically showing a structure of a pixel array in an image sensor according to another embodiment;
FIG. 26 is a block diagram of an electronic device including an image sensor according to an embodiment;
FIG. 27 is a block diagram of a camera module in FIG. 26;
FIG. 28 is a block diagram of an electronic device including a multi-camera module; and
FIG. 29 is a detailed block diagram of the multi-camera module in the electronic device of FIG. 28.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, an image sensor including a nano-photonic lens array and an electronic device including the image sensor will be described in detail with reference to accompanying drawings. Embodiments described herein are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

Singular forms include plural forms unless apparently indicated otherwise contextually. It will be further understood that when a portion is referred to as "comprising" another component, the portion may not exclude another component but may further comprise another component unless the context states otherwise.

In addition, the terms such as "... unit", "module", etc. provided herein indicates a unit performing a function or an operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe a technical detail, and the scope of rights is not limited by these terms unless the context is limited by the claims.

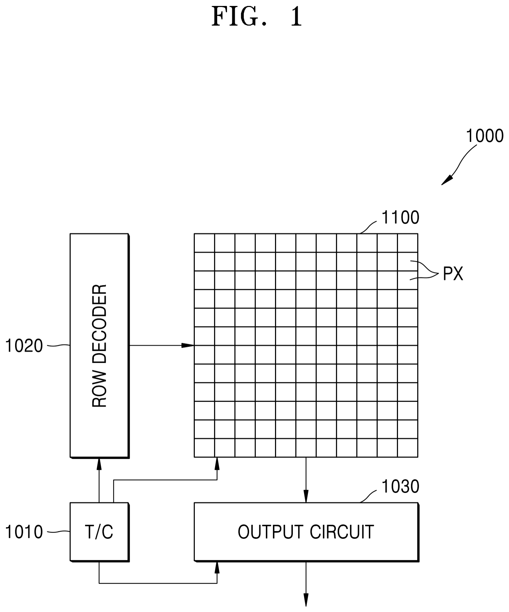

FIG. 1 is a schematic block diagram of an image sensor according to an embodiment. Referring to FIG. 1, an image sensor 1000 may include a pixel array 1100, a timing controller (T/C) 1010, a row decoder 1020, and an output circuit 1030. The image sensor 1000 may be a charge-coupled device (CCD) image sensor or a complementary metal oxide semiconductor (CMOS) image sensor.

The pixel array 1100 includes a plurality of pixels PX that are two-dimensionally disposed in a plurality of rows and a plurality of columns. The row decoder 1020 selects one of the rows in the pixel array 1100 in response to a row address signal output from the T/C 1010. The output circuit 1030 outputs a photosensitive signal from a plurality of pixels PX disposed in the selected row in a column unit. To this end, the output circuit 1030 may include a column decoder and an analog-to-digital converter (ADC). For example, the output circuit 1030 may include a plurality of ADCs that are respectively disposed in columns between the column decoder and the pixel array 1100, or one ADC disposed at an output end of the column decoder. The T/C 1010, the row decoder 1020, and the output circuit 1030 may be implemented as one chip or in separate chips. A processor for processing an image signal output from the output circuit 1030 may be implemented as one chip with the T/C 1010, the row decoder 1020, and the output circuit 1030.

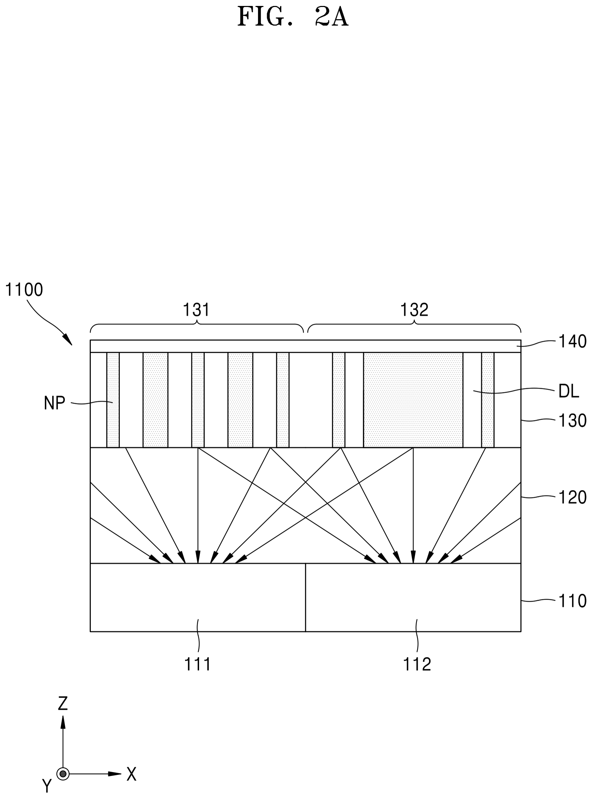

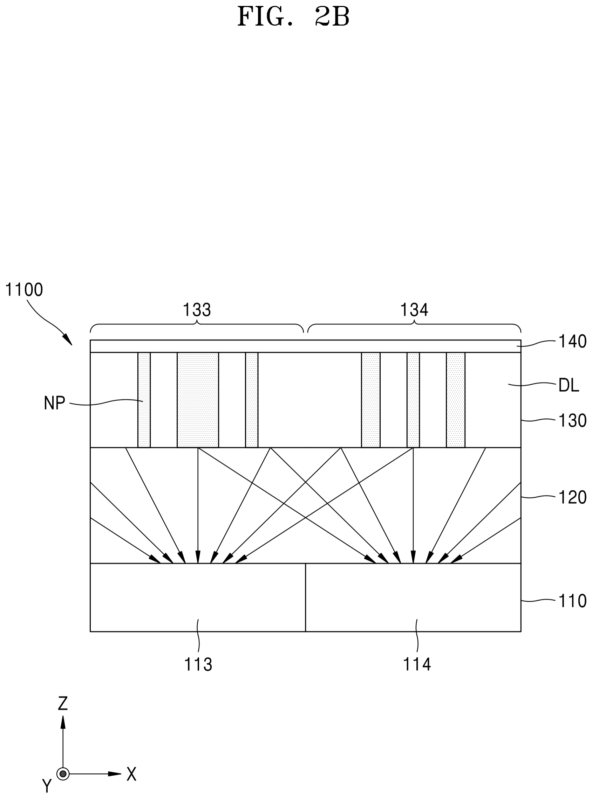

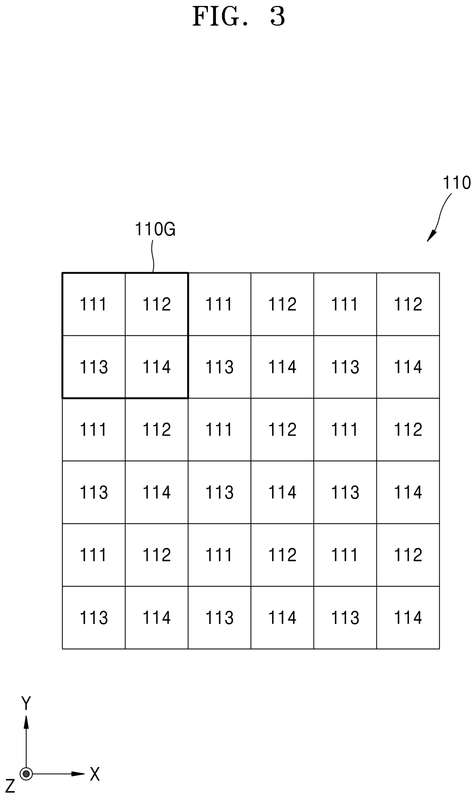

FIGS. 2A and 2B are cross-sectional views schematically showing a structure of the pixel array 1100 in the image sensor 1000 according to an embodiment. FIG. 2A shows a cross-section of the pixel array 1100 taken along a first direction (e.g., an X-axis direction), and FIG. 2B shows a cross-section of the pixel array 1100, taken along the first direction (the X-axis direction) at a location different from that of FIG. 2A in a second direction (e.g., a Y-axis direction) perpendicularly crossing the first direction. Referring to FIGS. 2A and 2B, the pixel array 1100 may include a sensor substrate 110, a spacer layer 120 provided on the sensor substrate 110, and a nano-photonic lens array 130 provided on the spacer layer 120. Also, the pixel array 1100 may further include an anti-reflection layer 140 provided on the nano-photonic lens array 130. The spacer layer 120 may be provided between the sensor substrate 110 and the nano-photonic lens array 130 in a third direction (e.g., a Z-axis direction). The nano-photonic lens array 130 may be provided between the spacer layer 120 and the anti-reflection layer 140 in the third direction. The sensor substrate 110 will be described in greater detail with reference to FIG. 3. Subsequently, FIGS. 2A and 2B will be revisited to describe additional elements of the pixel array 1100.

FIG. 3 shows an example of a pixel arrangement in the sensor substrate 110 according to an embodiment. Referring to FIG. 3, the sensor substrate 110 may include a plurality of unit pixel groups 110G that are two-dimensionally arranged in the first direction and the second direction. One unit pixel group 110G of the sensor substrate 110 may include a first pixel 111, a second pixel 112, a third pixel 113, and a fourth pixel 114. The first pixel 111, the second pixel 112, the third pixel 113, and the fourth pixel 114 may be two-dimensionally arranged in a 2x2 array in the first and second directions. In one row of the sensor substrate 110, a plurality of first pixels 111 and a plurality of second pixels 112 may be alternately arranged in a first direction, and a plurality of third pixels 113 and a plurality of fourth pixels 114 may be alternately arranged in the first direction in a row located differently in a second direction perpendicular to the first direction. Also, the plurality of first pixels 111 and the plurality of fourth pixels 114 may be alternately arranged in a first diagonal direction and the plurality of second pixels 112 and the plurality of third pixels 113 may be alternately arranged in a second diagonal direction crossing the first diagonal direction.

The first pixel 111, the second pixel 112, the third pixel 113, and the fourth pixel 114 may sense light of different colors. In an example, when the image sensor 1000 has a pixel arrangement of the Bayer pattern, the first pixel 111 and the fourth pixel 114 may be green pixels sensing green light, the second pixel 112 may be a red pixel sensing red light, and the third pixel 113 may be a blue pixel sensing blue light. In another example, the first pixel 111 and the fourth pixel 114 may be yellow pixels sensing yellow-based light, the second pixel 112 may be a red pixel sensing red light, and the third pixel 113 may be a blue pixel sensing blue light. In another example, the first pixel 111 and the fourth pixel 114 may be yellow pixels, the second pixel 112 may be a magenta pixel sensing magenta-based light, and the third pixel 113 may be a cyan pixel sensing cyan-based light.

Referring back to FIGS. 2A and 2B, the spacer layer 120 arranged between the sensor substrate 110 and the nano-photonic lens array 130 may provide a flat surface for forming the nano-photonic lens array 130 thereon. Also, the spacer layer 120 may maintain a gap between the sensor substrate 110 and the nano-photonic lens array 130 constantly. Also, the spacer layer 120 may provide a distance that is sufficient enough to color-separate the light by using the nano-photonic lens array 130. For example, a thickness of the spacer layer 120 may range from about 0.25 times to about 0.5 times of each pixel pitch. The spacer layer 120 may include a transparent material with respect to visible light. For example, the spacer layer 120 may include a dielectric material having a low refractive index than nano-structures NP that are described later and having a low absorbent ratio in the visible ray band, e.g., siloxane-based spin on glass (SOG), SiO₂, Si₃N₄, Al₂O₃, etc.

The nano-photonic lens array 130 may be provided on the spacer layer 120. FIGS. 2A and 2B show that the nano-photonic lens array 130 is directly provided on the spacer layer 120, but an etch-stop layer preventing the spacer layer 120 from being damaged during the process of forming the nano-photonic lens array 130 may be provided on the spacer layer 120 and the nano-photonic lens array 130 may be provided on the etch-stop layer. The nano-photonic lens array 130 may be configured to, from the light incident on the nano-photonic lens array 130, separate light of a first wavelength and condense the separated light of the first wavelength onto the first pixel 111 and the fourth pixel 114, separate light of a second wavelength that is different from the first wavelength and condense the separated light of the second wavelength onto the second pixel 112, and separate light of a third wavelength different from the first and second wavelengths and condense the separated light of the third wavelength onto the third pixel 113. For example, the light of the first wavelength may be green light, the light of the second wavelength may be red light, and the light of the third wavelength may be blue light. Alternatively, the light of the first wavelength may be yellow light, the light of the second wavelength may be red light, and the light of the third wavelength may be blue light. Alternatively, the light of the first wavelength may be yellow light, the light of the second wavelength may be magenta light, and the light of the third wavelength may be cyan light.

The nano-photonic lens array 130 may include the plurality of nano-structures NP formed to perform the above operations. Also, the nano-photonic lens array 130 may further include a dielectric material DL filled between the plurality of nano-structures NP. The nano-photonic lens array 130 may also include a plurality of first meta-regions 131, a plurality of second meta-regions 132, a plurality of third meta-regions 133, and a plurality of fourth meta-regions 134 in which the plurality of nano-structures NP are arranged based on different rules or predetermined patterns.

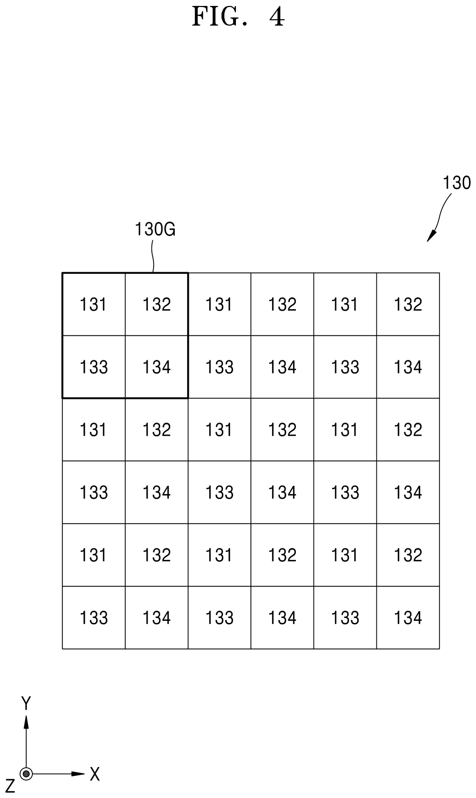

FIG. 4 shows an example of an arrangement of meta-regions in the nano-photonic lens array 130 according to an embodiment. Referring to FIG. 4, the nano-photonic lens array 130 may include a plurality of unit meta-groups 130G that are two-dimensionally arranged in the first and second directions. Each of the plurality of unit meta-groups 130G may include the first meta-region 131, the second meta-region 132, the third meta-region 133, and the fourth meta-region 134. The first meta-region 131, the second meta-region 132, the third meta-region 133, and the fourth meta-region 134 may be grouped and two-dimensionally arranged in a 2x2 array in the first and second directions. For example, the first meta-region 131 may be in contact with the second meta-region 132 in the first direction and may be in contact with the third meta-region 133 in the second direction. The second meta-region 132 may be in contact with the fourth meta-region 134 in the second direction and the third meta-region 133 may be in contact with the fourth meta-region 134 in the first direction.

In one row of the nano-photonic lens array 130, the plurality of first meta-regions 131 and the plurality of second meta-regions 132 may be alternately arranged in the first direction, and the plurality of third meta-regions 133 and the plurality of fourth meta-regions 134 may be alternately arranged in the first direction in one row differently located in the second direction. Also, the plurality of first meta-regions 131 and the plurality of fourth meta-regions 134 may be alternately arranged in a first diagonal direction, and the plurality of second meta-regions 132 and the plurality of third meta-regions 133 may be alternately arranged in a second diagonal direction crossing the first diagonal direction. The first meta-region 131 may face the first pixel 111 in the third direction, the second meta-region 132 may face the second pixel 112 in the third direction, the third meta-region 133 may face the third pixel 113 in the third direction, and the fourth meta-region 134 may face the fourth pixel 114 in the third direction.

The first meta-region 131, the second meta-region 132, the third meta-region 133, and the fourth meta-region 134 of the nano-photonic lens array 130 may each include at least one nano-structure NP arranged according to a certain rule or a predetermined pattern to condense color-separated light as described above. The plurality of nano-structures NP of the nano-photonic lens array 130 may be arranged such that a phase of light transmitting through the nano-photonic lens array 130 is differently changed according to a position on the nano-photonic lens array 130. A phase profile of the transmitted light, which is implemented by the nano-photonic lens array 130, may be determined according to a critical dimension (e.g., cross-sectional width or cross-sectional diameter), cross-sectional shape, and a height of each of the nano-structures NP, and the arrangement type of the plurality of nano-structures NP. Also, the behavior of the light passing through the nano-optical lens array 130 may be determined according to the phase profile of the transmitted light. For example, the plurality of nano-structures NP may be disposed to form a phase profile allowing the light transmitted through the nano-photonic lens array 130 to be separated according to wavelengths and condensed onto corresponding pixels.

The nano-structures NP may each have a critical dimension (e.g., cross-sectional width or cross-sectional diameter) of sub-wavelength dimension. The sub-wavelength refers to a wavelength that is less than a wavelength band of the light condensed by the nano-photonic lens array 130. When the incident light is a visible ray, the cross-sectional diameter of the nano-structure NP may be less than, for example, 400 nm, 300 nm, or 200 nm. A height of the nano-structure NP may be about 300 nm to about 1500 nm, which is greater than the cross-sectional diameter of the nano-structure.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (GaP, GaN, GaAs etc.), SiC, TiO₂, SiN₃, ZnS, ZnSe, Si₃N₄, and/or a combination thereof. Periphery of the nano-structures NP may be filled with a dielectric material DL having a relatively lower refractive index as compared with the nano-structures NP and have a relatively low absorbent ratio in the visible ray band. For example, the periphery of the nano-structures NP may be filled with siloxane-based spin on glass (SOG), SiO₂, Si₃N₄, Al₂O₃, air, etc.

The refractive index of a high-refractive index nano-structures NP may be about 2.0 or greater with respect to the light of about 630 nm wavelength, and the refractive index of a low-refractive index dielectric material DL may be about 1.0 to about 2.0 with respect to the light of about 630 nm wavelength. Also, a difference between the refractive indexes of the nano-structures NP and the refractive index of the dielectric material DL may be about 0.5 or greater. The nano-structures NP having a difference in a refractive index from the refractive index of the peripheral material may change the phase of light that passes through the nano-structures NP. This is caused by phase delay that occurs due to the shape dimension of the sub-wavelength of the nanostructures NP, and a degree at which the phase is delayed may be determined by a detailed shape dimension and arrangement shape of the nanostructures NP.

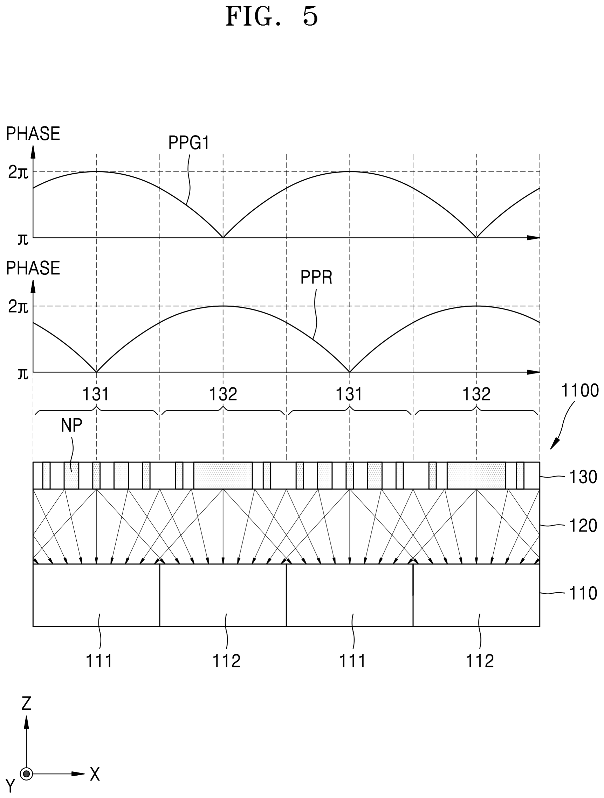

FIG. 5 shows an example of phase profiles of green light and red light after passing through the nano-photonic lens array 130. Referring to FIG. 5, the green light after passing through the nano-photonic lens array 130 may have a first green light phase profile PPG1 that is largest at the center of the first meta-region 131 and reduces away from the center of the first meta-region 131. In detail, immediately after passing through the nano-photonic lens array 130, that is, at a lower surface of the nano-photonic lens array 130 or an upper surface of the spacer layer 120, the phase delay of the green light is the largest at the center of the first meta-region 131 and reduced as a concentric circle away from the center of the first meta-region 131. Thus, the phase delay is the smallest at the centers of the second and third meta-regions 132 and 133 in the first direction and the second direction, and at contact points between the first meta-region 131 and the fourth meta-region 134 in the diagonal direction.

The red light that has passed through the nano-photonic lens array 130 may have a red light phase profile PPR that is largest at the center of the second meta-region 132 and reduces away from the center of the second meta-region 132. In detail, immediately after passing through the nano-photonic lens array 130, the phase delay of the red light is the largest at the center of the second meta-region 132 and reduces as a concentric circle away from the center of the second meta-region 132, and thus, the phase delay is the smallest at the centers of the first and fourth meta-regions 131 and 134 in the first direction and the second direction and the smallest at the center of the third meta-region 133 in the diagonal direction.

Then, the green light incident on the first meta-region 131 and surroundings of the first meta-region 131 may be condensed onto the first pixel 111 by the nano-photonic lens array 130. In other words, the green light coming from the second and third meta-regions 132 and 133, other than the first meta-region 131, may be incident on the first pixel 111. The red light incident on the second meta-region 132 and surroundings of the second meta-region 132 may be condensed onto the second pixel 112 by the nano-photonic lens array 130. In other words, the red light coming from the first meta-region 131, the third meta-region 133, and the fourth meta-region 134, other than the second meta-region 132, may be incident on the second pixel 112.

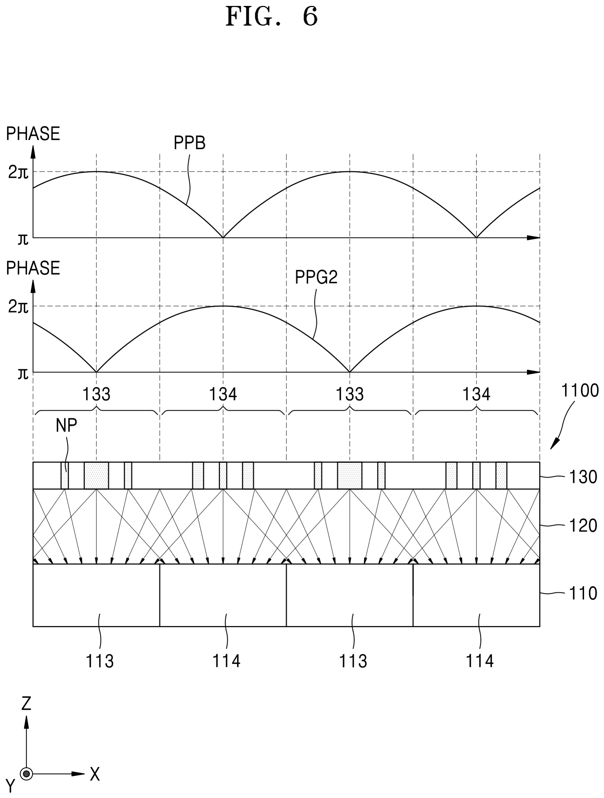

FIG. 6 shows an example of phase profiles of blue light and green light after passing through the nano-photonic lens array 130. Referring to FIG. 6, the blue light after passing through the nano-photonic lens array 130 may have a blue light phase profile PPB that is largest at the center of the third meta-region 133 and reduces away from the center of the third meta-region 133. In detail, immediately after passing through the nano-photonic lens array 130, that is, at a lower surface of the nano-photonic lens array 130 or an upper surface of the spacer layer 120, the phase delay of the blue light is the largest at the center of the third meta-region 133 and reduces as a concentric circle away from the center of the third meta-region 133. Thus, the phase delay is the smallest at the centers of the fourth and first meta-regions 134 and 131 in the first direction and the second direction, and at the center of the second meta-region 132 in the diagonal direction.

Also, the green light that has passed through the nano-photonic lens array 130 may have a second green light phase profile PPG2 that is largest at the center of the fourth meta-region 134 and reduces away from the center of the fourth meta-region 134. In detail, immediately after passing through the nano-photonic lens array 130, that is, at a lower surface of the nano-photonic lens array 130 or an upper surface of the spacer layer 120, the phase delay of the green light is the largest at the center of the fourth meta-region 134 and reduces as a concentric circle away from the center of the fourth meta-region 134. Thus, the phase delay is the smallest at the centers of the third and second meta-regions 133 and 132 in the first direction and the second direction, and at contact points between the fourth meta-region 134 and the first meta-region 131 in the diagonal direction.

Then, the blue light incident on the third meta-region 133 and surroundings of the third meta-region 133 may be condensed onto the third pixel 113 by the nano-photonic lens array 130. In other words, the blue light coming from the first meta-region 131, the second meta-region 132, and the fourth meta-region 134, other than the third meta-region 133, may be incident on the third pixel 113. The green light incident on the fourth meta-region 134 and surroundings of the fourth meta-region 134 may be condensed onto the fourth pixel 114 by the nano-photonic lens array 130. In other words, the green light coming from the second and third meta-regions 132 and 133, other than the fourth meta-region 134, may be incident on the fourth pixel 114.

Also, the nano-photonic lens array 130 according to the embodiment may have a polarization-separating characteristic along with the color-separating characteristic described above. For example, the nano-photonic lens array 130 according to the embodiment may be configured to condense green light having a first polarization component, in the light incident on the nano-photonic lens array 130, onto the first pixel 111 and condense green light having a second polarization component that is in a different direction from the first polarization component, in the light incident on the nano-photonic lens array 130, onto the fourth pixel 114. To this end, at least one of the plurality of nano-structures NP in the nano-photonic lens array 130 may be configured to allow the light having the polarization component of different direction to be separated and proceed in the different direction.

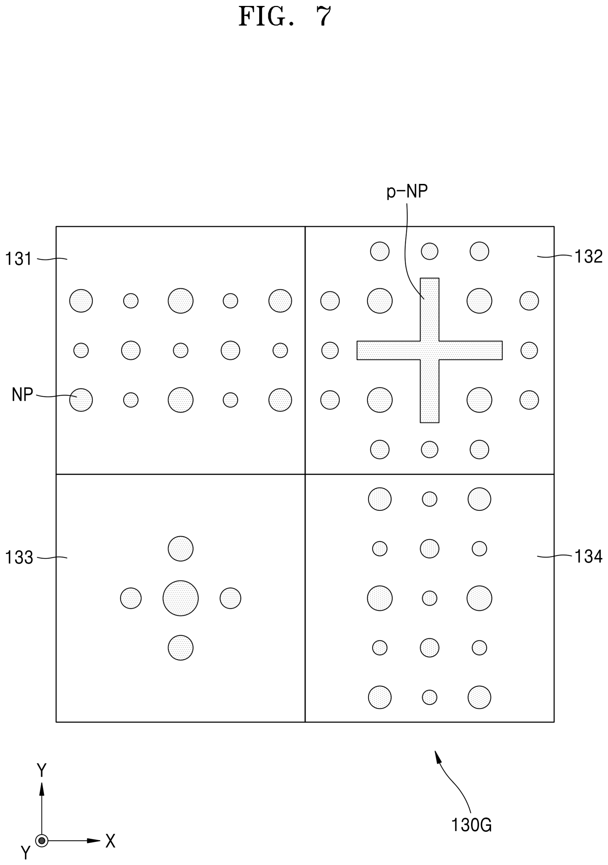

FIG. 7 shows an example of an arrangement of the plurality of nano-structures NP in a unit meta-group 130G of the nano-photonic lens array 130 according to the embodiment. Referring to FIG. 7, the unit meta-group 130G may include the first meta-region 131, the second meta-region 132, the third meta-region 133, and the fourth meta-region 134. Each of the unit meta-group 130G may include the first meta-region 131, the second meta-region 132, the third meta-region 133, and the fourth meta-region 134 each including at least one nano-structure NP arranged according to a certain rule or a predetermined pattern to condense color-separated light as described above.

In the example of FIG. 7, the plurality of nano-structures NP arranged in the first meta-region 131 and the fourth meta-region 134 may be arranged in a 2-fold symmetry structure. In the first meta-region 131, the plurality of nano-structures NP may be arranged to be mirror-symmetrical in the first direction and the second direction (e.g., x-axis and y-axis) relative to the center of the first meta-region 131. In the fourth meta-region 134, the plurality of nano-structures NP may be arranged to be mirror-symmetrical in the first direction and the second direction relative to the center of the fourth meta-region 134. Also, the arrangement type of the plurality of nano-structures NP in the fourth meta-region 134 may be rotated by 90-degree angle with respect to the arrangement of the plurality of nano-structures NP in the first meta-region 131.

In the second and third meta-regions 132 and 133, the plurality of nano-structures NP may be arranged according to a structural rule or a predetermined pattern that is different from that of the plurality of nano-structures NP in the first and fourth meta-regions 131 and 134. For example, the plurality of nano-structures NP arranged in the second and third meta-regions 132 and 133 may be arranged in a 4-fold symmetry structure. In the second meta-region 132, the plurality of nano-structures NP may be arranged to be mirror-symmetrical in the first direction, the second direction, and two diagonal directions, relative to the center of the second meta-region 132. In the third meta-region 133, the plurality of nano-structures NP may be arranged to be mirror-symmetrical in the first direction, the second direction, and two diagonal directions relative to the center of the third meta-region 133.

FIG. 7 shows that the plurality of nano-structures NP have cylindrical shapes, but cross-sectional shapes of the nano-structures NP are not limited thereto. According to a structural requirement of the nano-photonic lens array 130, the nano-structures NP may have column shapes with various cross-sections such as rectangular, triangular, or other geometries. Also, in FIG. 7, the first meta-region 131, the second meta-region 132, the third meta-region 133, and the fourth meta-region 134 each include the plurality of nano-structures NP having various diameters, but at least one of the first meta-region 131, the second meta-region 132, the third meta-region 133, and the fourth meta-region 134 may include only one nano-structure NP.

Also, according to the embodiment, at least one of the nano-structures NP arranged in at least one of the second meta-region 132 and the third meta-region 133 may be a polarization-separating nano-structure p-NP having a polarization-separating characteristics. FIG. 7 shows an example in which the second meta-region 132 includes the polarization-separating nano-structure p-NP. As shown in FIG. 7, the second meta-region 132 may further include the polarization-separating nano-structure p-NP along with non-polarization nano-structures NP. For example, the polarization-separating nano-structure p-NP is provided at the center of the second meta-region 132, and the remaining nano-structures NP lacking polarization-separating characteristics may be arranged around the polarization-separating nano-structure p-NP in a 4-fold symmetry structure.

The polarization-separating nano-structure p-NP may be configured to selectively direct components of incident light based on polarization. For example, when light of the first wavelength is incident on the second meta-region 132, the polarization-separating nano-structure p-NP may transmit the light having a first polarization component (e.g., linear polarization component in the first direction) to the first pixel 111 and transmit light having a second polarization component (e.g., linear polarization component in the second direction) to the fourth pixel 114, wherein the second polarization component has a polarization direction different from the first polarization component. When the light of the first wavelength is incident on the second meta-region 132, the polarization-separating nano-structure p-NP may transmit the light of the second polarization component to the first pixel 111 and transmit the light of the first polarization component to the fourth pixel 114.

For example, when the image sensor 1000 has a Bayer pattern pixel arrangement, the polarization-separating nano-structure p-NP may be configured to transmit green light of a first polarization component to the first pixel 111 and transmit the green light of a second polarization component to the fourth pixel 114, from among the green light incident on the second meta-region 132. In other embodiment, the polarization-separating nano-structure p-NP may be configured to transmit the green light of the second polarization component to the first pixel 111 and transmit the green light of the first polarization component to the fourth pixel 114, from among the green light incident on the second meta-region 132.

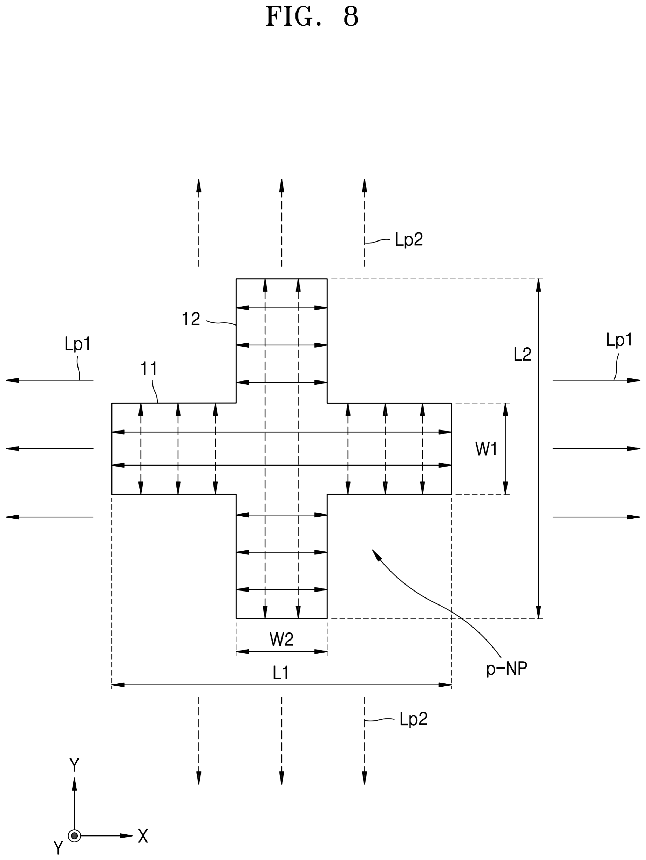

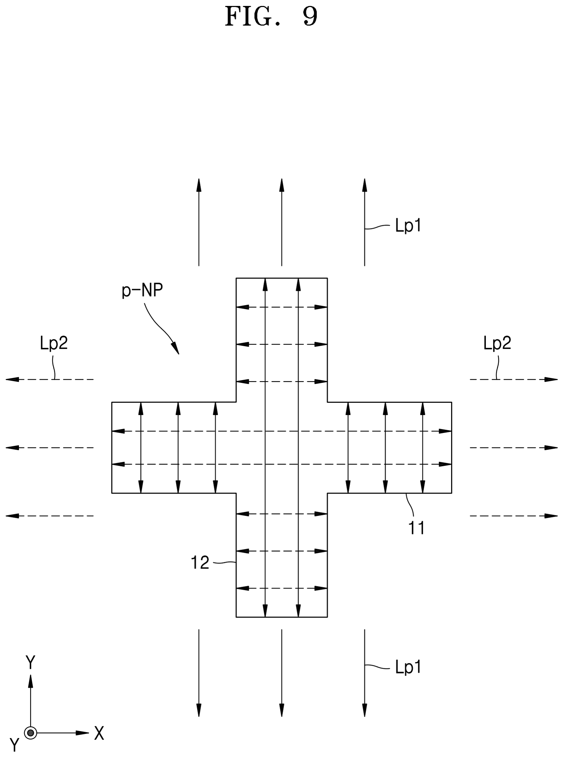

FIGS. 8 and 9 show examples of an operation of a polarization-separating nano-structure p-NP. The polarization-separating nano-structure p-NP may be implemented with a cross-shaped geometry, including a center portion and four arms that extend outward from the center portion. The number of arms is not limited to four, and a greater or fewer number of arms may be connected to the center portion, depending on the structural requirements. Referring to FIG. 8, the polarization-separating nano-structure p-NP may include a first extension portion 11 extending in the first direction and a second extension portion 12 extending in the second direction. The first extension portion 11 and the second extension portion 12 may cross each other at the center thereof. The first extension portion 11 may include two arms and the center portion, aligned along the first direction, while the second extension portion 12 may include the other two arms and the center portion, aligned along the second direction. For example, the polarization-separating nano-structure p-NP may have a cross shape. The first extension portion 11 may have a first length L1 in the first direction and a first width W1 in the second direction. The second extension portion 12 may have a second length L2 in the second direction and a second width W2 in the first direction. The first length L1 may be greater than the first width W1 and the second length L2 may be greater than the second width W2. In an example, the first length L1 and the second length L2 are equal to each other and the first width W1 and the second width W2 may be equal to each other, but are not limited thereto. The polarization-separating nano-structure (p-NP) may be formed as an integrated single body (i.e., a single-layer structure). However, the embodiments are not limited to this configuration, and the first extension portion 11 and the second extension portion 12 may be formed as separate layers and stacked on top of each other to achieve the cross-shaped structure.

The polarization-separating characteristics of the polarization-separating nano-structure p-NP may be determined according to a refractive index of the material in the polarization-separating nano-structure p-NP, a height of the polarization-separating nano-structure p-NP, the first length L1 and the second width W1 of the first extension portion 11, and the second length L2 and the second width W2 of the second extension portion 12. When it is assumed that the polarization-separating nano-structure p-NP has the same material and the same height as those of the other nano-structures NP, the polarization-separating characteristics of the polarization-separating nano-structure p-NP may be determined mainly according to the first length L1 and the first width W1 of the first extension portion 11, and the second length L2 and the second width W2 of the second extension portion 12. However, as necessary, the polarization-separating nano-structure p-NP may have a different material as that of the other nano-structures NP, and may have different height from those of the other nano-structures NP.

In the example shown in FIG. 8, the first length L1 and the first width W1 of the first extension portion 11 and the second length L2 and the second width W2 of the second extension portion 12 may be determined so that when the light of the first wavelength is incident on the second meta-region 132, first light Lp1 having the first polarization component resonates in the first direction due to the polarization-separating nano-structure p-NP, and second light Lp2 having the second polarization component resonates in the second direction due to the polarization-separating nano-structure p-NP. Then, in the light of the first wavelength incident on the second meta-region 132, the first light Lp1 having the first polarization component may be emitted in the first direction and the second light Lp2 having the second polarization component may be emitted in the second direction. Accordingly, in the light of the first wavelength incident on the second meta-region 132, the first light Lp1 having the first polarization component may be condensed onto the first pixel 111 and the second light Lp2 having the second polarization component may be condensed onto the fourth pixel 114. Therefore, the nano-photonic lens array 130 may be configured to condense the light of the first wavelength having the first polarization component, in the light incident on the nano-photonic lens array 130, onto the first pixel 111 and condense the light of the first wavelength having the second polarization component, in the light incident on the nano-photonic lens array 130, onto the fourth pixel 114,.

In the example shown in FIG. 9, the first length L1 and the first width W1 of the first extension portion 11 and the second length L2 and the second width W2 of the second extension portion 12 may be determined so that, when the light of the first wavelength is incident on the second meta-region 132, second light Lp2 having the second polarization component resonates in the first direction due to the polarization-separating nano-structure p-NP and the first light Lp1 having the first polarization component resonates in the second direction due to the polarization-separating nano-structure p-NP. Then, in the light of the first wavelength incident on the second meta-region 132, the second light Lp2 having the second polarization component may be emitted in the first direction and the first light Lp1 having the first polarization component may be emitted in the second direction. Accordingly, in the light of the first wavelength incident on the second meta-region 132, the second light Lp2 having the second polarization component may be condensed onto the first pixel 111 and the first light Lp1 having the first polarization component may be condensed onto the fourth pixel 114. In this case, the nano-photonic lens array 130 may be configured to condense the light of the first wavelength having the second polarization component, in the light incident on the nano-photonic lens array 130, onto the first pixel 111 and condense the light of the first wavelength having the first polarization component, in the light incident on the nano-photonic lens array 130, onto the fourth pixel 114. So far, it is described that the first polarization component is the linear polarization component in the first direction and the second polarization component is the linear polarization component in the second direction, but the disclosure is not limited thereto. In another example, the first polarization component may be the linear polarization component in the second direction and the second polarization component may be the linear polarization component in the first direction.

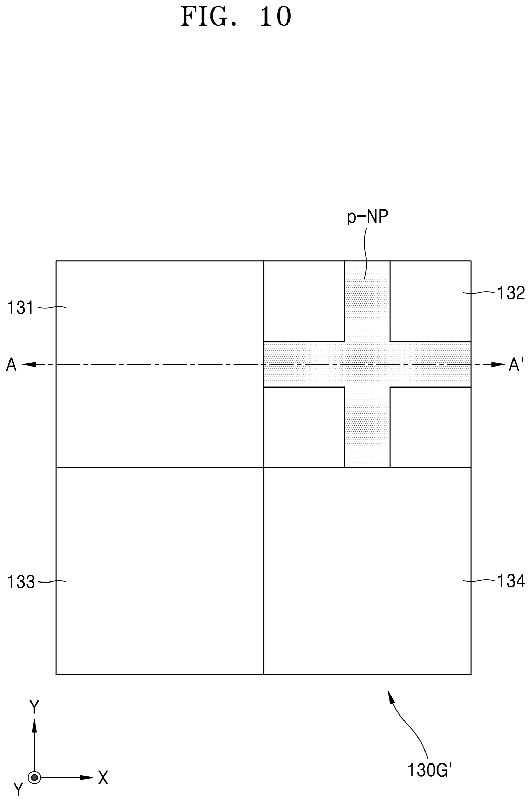

FIG. 10 shows an example of a unit meta-group in a nano-photonic lens array used for testing polarization-separating characteristics of a polarization-separating nano-structure p-NP. In this test configuration, a unit meta group 130G' of a nano-photonic lens array includes only the second meta-region 132 containing a single polarization-separating nano-structure p-N, while the first meta-region 131, the third meta-region 133, and the fourth meta-region 134 do not have nano-structures.

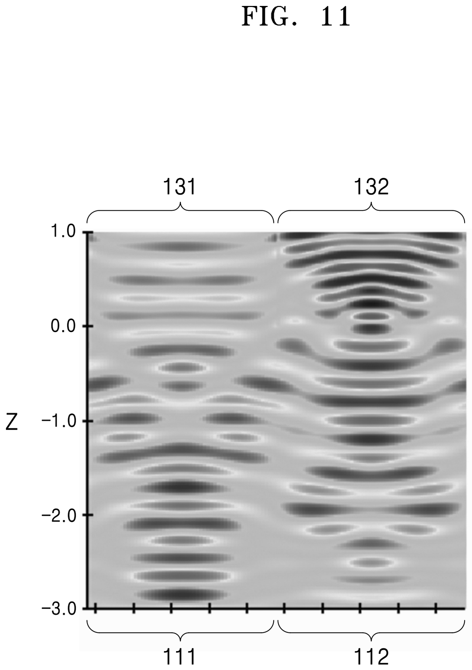

FIG. 11 shows an example of a distribution of light having a first polarization component in green light having passed through the nano-photonic lens array for test shown in FIG. 10, on cross-sections of a first meta-region 131 and a second meta-region 132. In other words, FIG. 11 shows a distribution of green light having a first polarization component, which proceeds in the third direction on a vertical section taken along line A-A' of FIG. 10. Referring to FIG. 11, the green light having the first polarization component may proceed toward the first pixel 111.

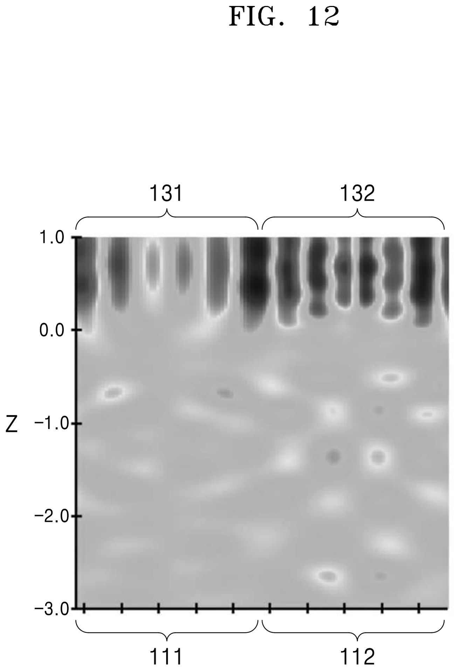

FIG. 12 shows an example of a distribution of light having a second polarization component in green light having passed through the nano-photonic lens array for test shown in FIG. 10, on cross-sections of a first meta-region 131 and a second meta-region 132. In other words, FIG. 12 shows a distribution of green light having a second polarization component, which proceeds in the third direction on a vertical section taken along line A-A' of FIG. 10. Referring to FIG. 12, the green light having the second polarization component may rarely proceed toward the first pixel 111.

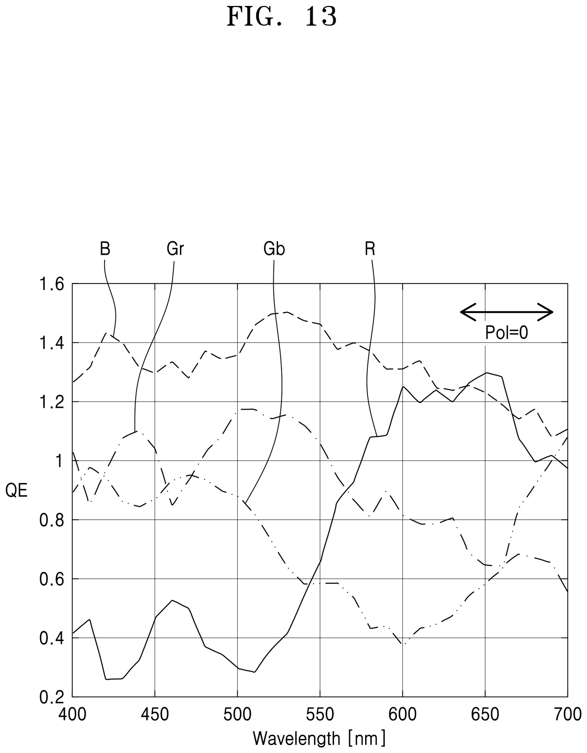

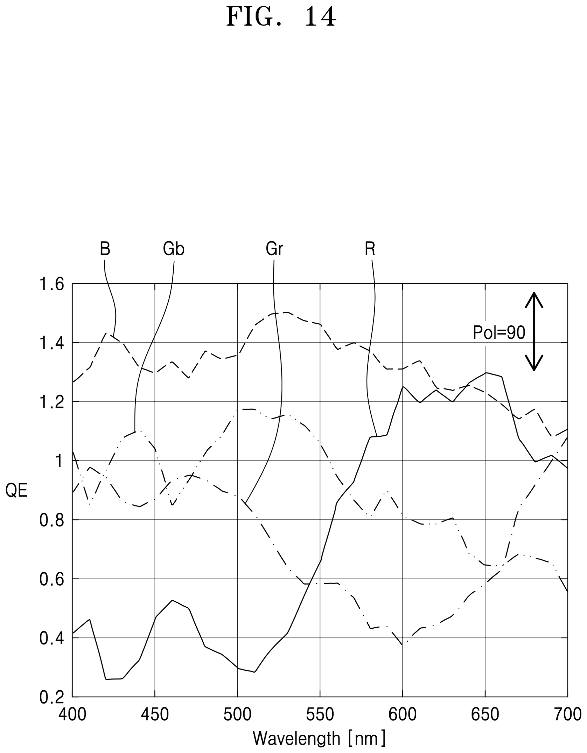

FIG. 13 is a graph showing an example of a quantum efficiency (QE) with respect to light having a first polarization component in an image sensor including the nano-photonic lens array for test shown in FIG. 10. FIG. 14 is a graph showing an example of a QE with respect to light having a second polarization component in an image sensor including the nano-photonic lens array for test shown in FIG. 10. In FIGS. 13 and 14, a graph indicated by Gr denotes a QE with respect to the light detected from the first pixel 111, a graph indicated by R denotes a QE with respect to the light detected from the second pixel 112, a graph indicated by B denotes a QE with respect to the light detected from the third pixel 113, and a graph indicated by Gb denotes a QE with respect to the light detected from the fourth pixel 114.

Referring to FIGS. 13 and 14, in the nano-photonic lens array for test shown in FIG. 10, because the polarization-separating nano-structure p-NP only exists in the second meta-region 132 and the nano-structures do not exist in the other meta-regions, the color separation only occurs with respect to the red light and may rarely occurs with respect to the blue light and the green light. In addition, in the second pixel 112 and the third pixel 113, the QEs with respect to the light having the first polarization component and the light having the second polarization component may be equal to each other. On the contrary, the QEs with respect to the light having the first polarization component and the second polarization component in the first pixel 111 may be opposite to the QEs with respect to the light having the first polarization component and the light having the second polarization component in the fourth pixel 114. In particular, within a wavelength range of about 500 nm to about 600 nm, the QE with respect to the light having the first polarization component detected from the first pixel 111 may be greater than that with respect to the light having the first polarization component detected from the fourth pixel 114, and the QE with respect to the light having the second polarization component detected from the fourth pixel 114 may be greater than the QE with respect to the light having the second polarization component detected from the first pixel 111.

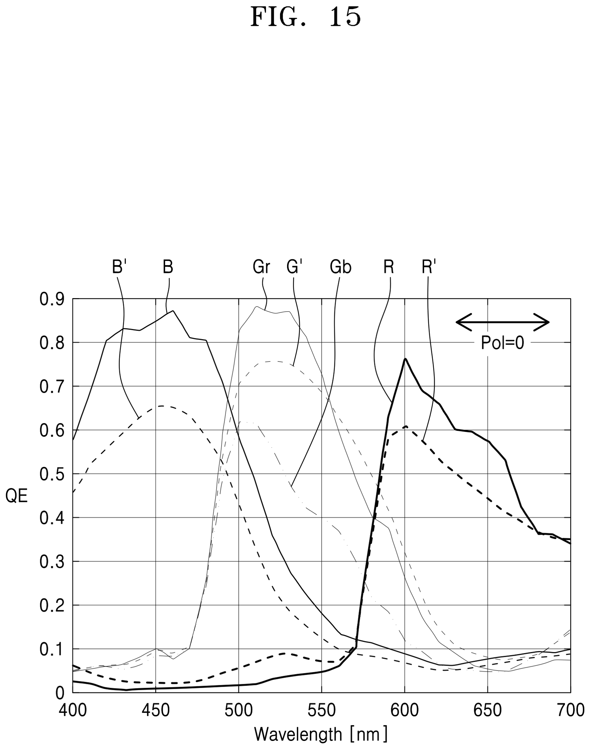

FIG. 15 is a graph showing an example of a quantum efficiency with respect to light having a first polarization component in an image sensor in which the nano-photonic lens array for test shown in FIG. 10 and a color filter are combined. In FIG. 15, dashed-line graphs indicated by B', G', and R' denote QEs with respect to the blue light, green light, and red light having the first polarization component in an image sensor only including a color filter without using the nano-photonic lens array for test, for the comparison. Referring to FIG. 15, even when the polarization-separating nano-structure p-NP only exists in the second meta-region 132, the QE with respect to the red light having the first polarization component in the second pixel 112 and the QE with respect to the blue light having the first polarization component in the third pixel 113 may increase slightly as compared with the case of using the color filter only. Also, in the first pixel 111, the QE with respect to the green light having the first polarization component may slightly increase as compared with the case of using the color filter only. In the fourth pixel 114, the QE with respect to the green light having the first polarization component may be less than that of the case of using the color filter only.

Therefore, by using the polarization-separating nano-structure p-NP, the light of the first wavelength (e.g., green light) having the first polarization component may be incident on the first pixel 111 more than on the fourth pixel 114, and the light of the first wavelength (e.g., green light) having the second polarization component may be incident on the fourth pixel 114 more than on the first pixel 111. In other words, in the light of the first wavelength incident on the first pixel 111, the intensity of the light having the first polarization component is greater than that of the light having the second polarization component, and in the light of the first wavelength incident on the fourth pixel 114, the intensity of the light having the second polarization component may be greater than that of the light having the first polarization component. For example, in the light of the first wavelength incident on the first pixel 111, the intensity of the light having the first polarization component may be about 1.5 times, about two times, or about three times greater than that of the light having the second polarization component. Also, in the light of the first wavelength incident on the fourth pixel 114, the intensity of the light having the second polarization component may be about 1.5 times, about two times, or about three times greater than that of the light having the first polarization component.

As described above, because the nano-photonic lens array 130 described above may separate the incident light by wavelengths and condense the separated light without absorbing or blocking the incident light, the light utilization efficiency of an image sensor 1000 may be improved. Also, the nano-photonic lens array 130 according to the embodiment may separately condense, in the incident light, the light having different polarization components on different pixels. Therefore, the image sensor 1000 may analyze accurately and abundantly the image. For example, the image sensor 1000 may finely sense surface characteristics of a material, e.g., material, shape, fine structure, scratch, roughness, smudges, etc., and may accurately observe inside of water surface by removing reflected light from the surface of the water, or may accurately identify an object on an opposite side of a window by removing reflected light from the surface of the window.

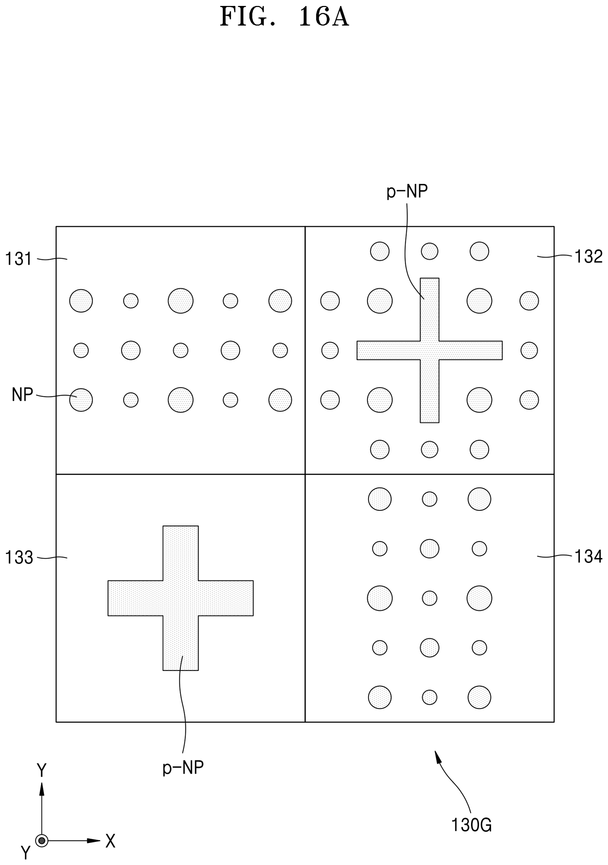

In the unit meta-group 130G of the nano-photonic lens array 130 shown in FIG. 7, the arrangement of the plurality of nano-structures NP and the polarization-separating nano-structure p-NP is an example, and various other arrangements are possible. FIGS. 16A to 16F show examples of arrangements of a plurality of nano-structures in a unit meta-group 130G in a nano-photonic lens array 130 according to some embodiments.

Referring to FIG. 16A, the third meta-region 133, as well as the second meta-region 132, may include the polarization-separating nano-structure p-NP. The polarization-separating nano-structure p-NP provided in the second meta-region 132 may be configured to transmit, in the light incident on the second meta-region 132, the light of the first wavelength having the first polarization component to the first pixel 111 in the first direction and transmit the light of the first wavelength having the second polarization component to the fourth pixel 114 in the second direction. The polarization-separating nano-structure p-NP provided in the third meta-region 133 may be configured to transmit, in the light incident on the third meta-region 133, the light of the first wavelength having the first polarization component to the first pixel 111 in the second direction and transmit the light of the first wavelength having the second polarization component to the fourth pixel 114 in the first direction.

To this end, as described above with reference to FIGS. 8 and 9, the polarization-separating nano-structure p-NP provided in the second meta-region 132 and the polarization-separating nano-structure p-NP provided in the third meta-region 133 have different sizes from each other. For example, the polarization-separating nano-structure p-NP provided in the second meta-region 132 and the polarization-separating nano-structure p-NP provided in the third meta-region 133 may be different from each other in at least one of the first length L1 of the first extension portion 11, the first width W1 of the first extension portion 11, the second length L2 of the second extension portion 12, and the second width W2 of the second extension portion 12 shown in FIG. 8.

FIG. 16A shows an example in which the third meta-region 133 includes only the polarization-separating nano-structure p-NP and does not include non-polarization nano-structures NP having no polarization-separating characteristics, but is not limited thereto. In another example, the third meta-region 133 may include non-polarization nano-structures NP along with the polarization-separating nano-structure p-NP. Also, FIG. 16A shows that the second meta-region 132 and the third meta-region 133 both include the polarization-separating nano-structure p-NP, but the polarization-separating nano-structure p-NP may be only provided in the third meta-region 133, and the second meta-region 132 may only include non-polarization nano-structures NP having no polarization-separating characteristics.

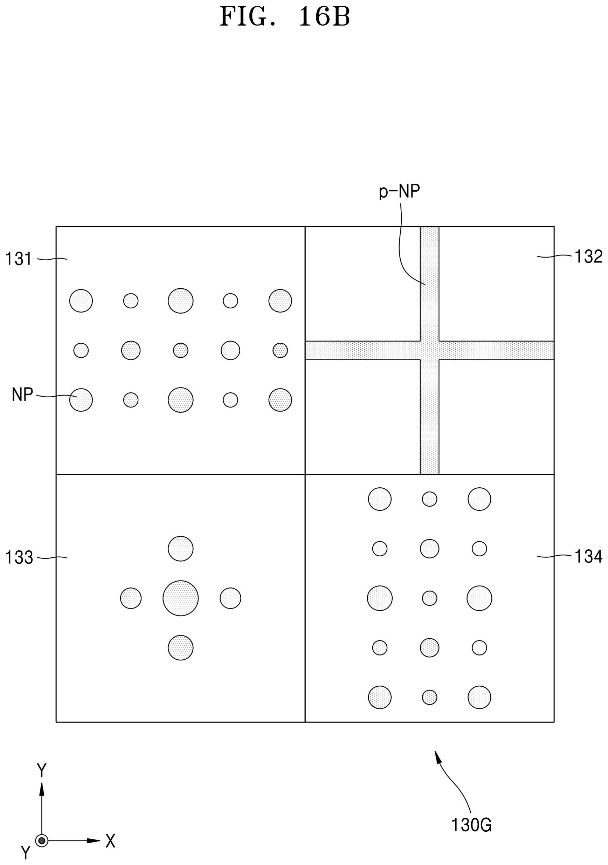

The first length L1 of the first extension portion 11 and the second length L2 of the second extension portion 12 in the polarization-separating nano-structure p-NP are less than the size of the meta-region in which the polarization-separating nano-structure p-NP is provided, but are not limited thereto. Referring to FIG. 16B, the first length L1 of the first extension portion 11 and/or the second length L2 of the second extension portion 12 of the polarization-separating nano-structure p-NP may be equal to the width of the meta-region in which the polarization-separating nano-structure p-NP is provided. For example, when the second meta-region 132 includes the polarization-separating nano-structure p-NP, the first length L1 of the first extension portion 11 of the polarization-separating nano-structure p-NP may be equal to the width of the second meta-region 132 in the first direction and/or the second length L2 of the second extension portion 12 of the polarization-separating nano-structure p-NP may be equal to the width of the second meta-region 132 in the second direction. When the third meta-region 133 includes the polarization-separating nano-structure p-NP, the first length L1 of the first extension portion 11 of the polarization-separating nano-structure p-NP may be equal to the width of the third meta-region 133 in the first direction and/or the second length L2 of the second extension portion 12 of the polarization-separating nano-structure p-NP may be equal to the width of the third meta-region 133 in the second direction.

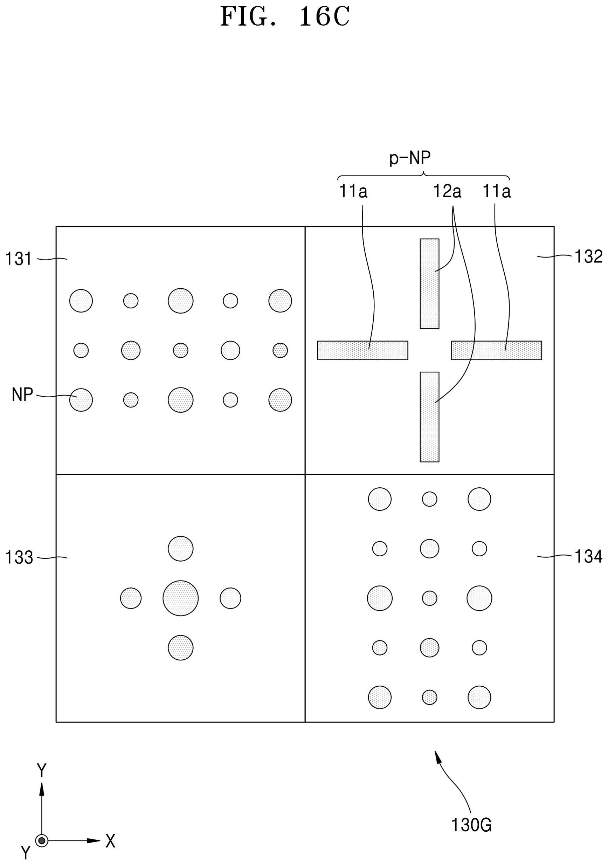

The first extension portion 11 and the second extension portion 12 of the polarization-separating nano-structure p-NP are described to have an integrated structure in which the first extension portion 11 and the second extension portion 12 come into contact integrally with each other at a cross point and extend in different directions, but is not limited thereto. For example, a structure including four disjoint arms extending outwards in opposing directions, without a central intersection region, may be provided as the polarization-separating nano-structure p-NP. Referring to FIG. 16C, the polarization-separating nano-structure p-NP may have a centerless cross-shaped configuration, including a plurality of first extension portions 11a (e.g., two disjoint arms) and a plurality of second extension portions 12a (e.g., two additional disjoint arms) that are spaced apart from one another. For example, the polarization-separating nano-structure p-NP may include two first extension portions 11a and two second extension portions 12a. The two first extension portions 11a are spaced apart from each other and may be arranged in a row in the first direction. Each of the two first extension portions 11a may have a rectangular shape extending in the first direction. The two second extension portions 12a are spaced apart from each other and may be arranged in a row in the second direction. Each of the two second extension portions 12a may have a rectangular shape extending in the second direction. This disjoint arrangement results in a cross-shaped layout without a central connecting region, enabling polarization-selective interaction based on spatially distributed resonance.

Facing end portions of the two first extension portions 11a may be symmetrically spaced apart from the center of the meta-region (e.g., second meta-region 132 or third meta-region 133), in which the polarization-separating nano-structure p-NP is provided, by the same distance in the first direction. Likewise, facing end portions of the two second extension portions 12a may be symmetrically spaced apart from the center of the meta-region (e.g., second meta-region 132 or third meta-region 133), in which the polarization-separating nano-structure p-NP is provided, by the same distance in the second direction. Also, the facing end portions of the two first extension portions 11a may be spaced apart from the facing end portions of the two second extension portions 12a, maintaining a defined separation between them.

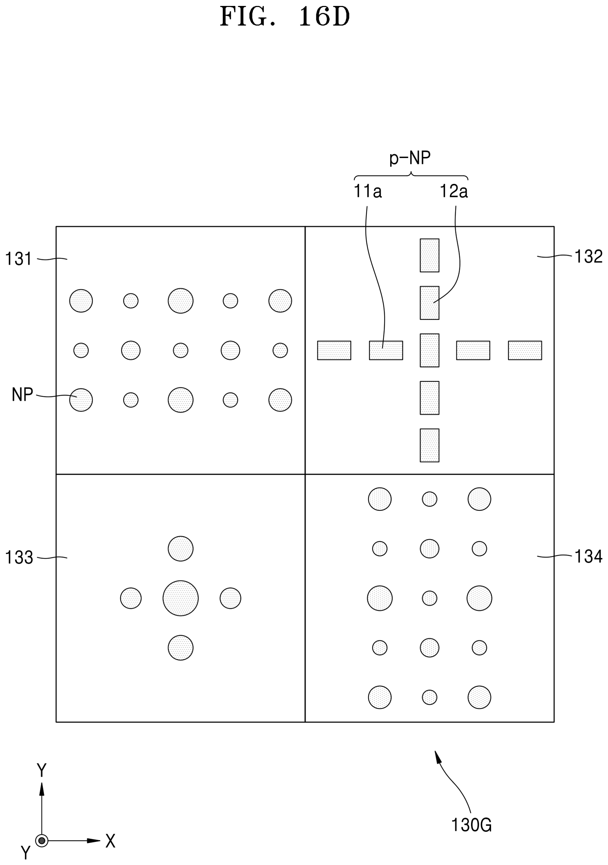

The polarization-separating nano-structure p-NP may include multiple discrete elements (e.g., rectangular, square, or circular pieces) arranged spatially to form an overall cross-shaped layout. These individual elements may be positioned along orthogonal axes extending from a central region, with each arm of the cross formed by one or more of these discrete pieces. The arrangement may not require a continuous central portion, and rather, the spatial distribution and alignment of the elements collectively define a cross-shaped configuration that enables polarization separation. For example, referring to FIG. 16D, the polarization-separating nano-structure p-NP may include a plurality of first extension portions 11a greater than two and a plurality of second extension portions 12a greater than two. For example, FIG. 16D shows that the polarization-separating nano-structure p-NP includes four first extension portions 11a and five second extension portions 12a, but is not limited thereto. The plurality of first extension portions 11a are spaced apart from each other and may be arranged in a row in the first direction. Each of the plurality of first extension portions 11a may have a rectangular shape extending in the first direction. The plurality of second extension portions 12a are spaced apart from each other and may be arranged in a row in the second direction. Each of the plurality of second extension portions 12a may have a rectangular shape extending in the second direction. The number of the first extension portions 11a and the number of the second extension portions 12a may be equal to each other, but are not limited thereto. For example, there may be one more first extension portions 11a than the second extension portions, or there may be one more second extension portions 12a than the first extension portions 11a.

The plurality of first extension portions 11a and the plurality of second extension portions 12a may cross each other at the center of the second meta-region 132 or the third meta-region 133 in which the polarization-separating nano-structure p-NP is provided, so that the polarization-separating nano-structure p-NP has an entirely cross shape. In other words, the plurality of first extension portions 11a and the plurality of second extension portions 12a may be arranged so that a line segment in the first direction connecting centers of the plurality of first extension portions 11a and a line segment in the second direction connecting centers of the plurality of second extension portions 12a cross each other at the center of the second meta-region 132 or the third meta-region 133 in which the polarization-separating nano-structure p-NP is provided.

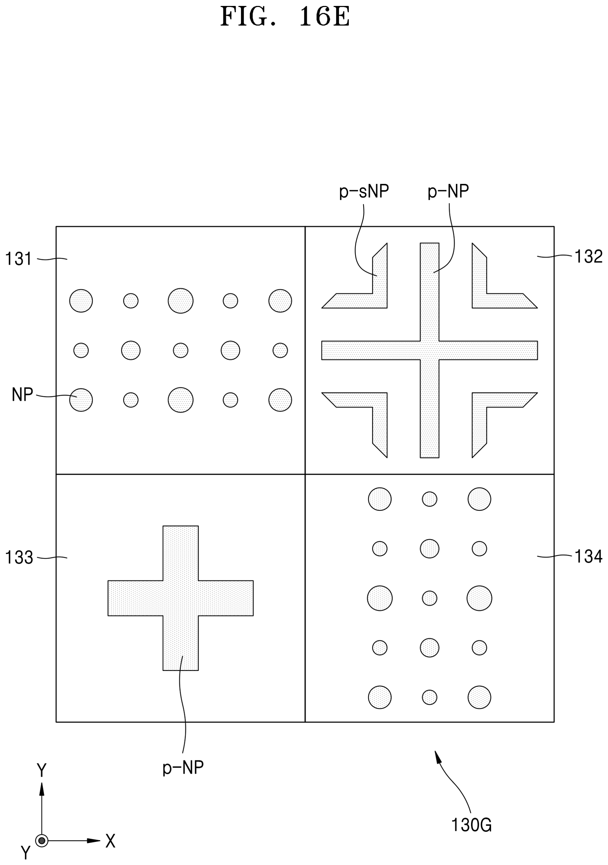

Referring to FIG. 16E, the second meta-region 132 of the nano-photonic lens array 130 may further include a plurality of polarization-separating sub-nano structures p-sNP for further improving the polarization-separating effect by assisting the operations of the polarization-separating nano-structure p-NP. Each of the plurality of polarization-separating sub-nano structures p-sNP may have a shape in which one end of the first extension portion in the first direction and one end of the second extension portion in the second direction are integrally connected at an angle of 90-degree. For example, four polarization-separating sub-nano structures p-sNP may be arranged symmetrically around the polarization-separating nano-structure p-NP.

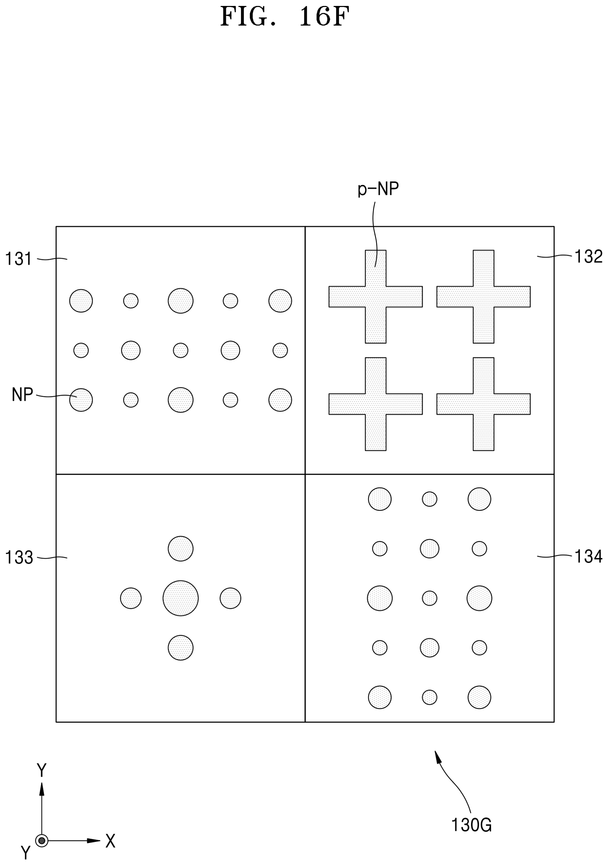

Referring to FIG. 16F, the second meta-region 132 of the nano-photonic lens array 130 may include a plurality of polarization-separating nano-structures p-NP. For example, four polarization-separating nano-structures p-NP may be symmetrically arranged in the second meta-region 132.

FIGS. 16B to 16F illustrate that the polarization-separating nano-structure p-NP and the polarization-separating sub-nano structures p-sNP are provided in the second meta-region 132, but the disclosure is not limited thereto. The polarization-separating nano-structure p-NP and the polarization-separating sub-nano structures p-sNP illustrated above with reference to FIGS. 16B to 16F may be also provided in the third meta-region 133. The polarization-separating nano-structure p-NP and the polarization-separating sub-nano structures p-sNP provided in the third meta-region 133 may be arranged to have polarization properties rotated by 90-degree with respect to the polarization-separating nano-structure p-NP and the polarization-separating sub-nano structures p-sNP provided in the second meta-region 132. Therefore, sizes of the polarization-separating nano-structure p-NP and the polarization-separating sub-nano structures p-sNP provided in the third meta-region 133 may be different from those of the polarization-separating nano-structure p-NP and the polarization-separating sub-nano structures p-sNP provided in the second meta-region 132.

The shapes and arrangement of the polarization-separating nano-structure p-NP and the polarization-separating sub-nano structures p-sNP may be based on the arrangement rules of the nano-structures NP described above with respect to the second meta-region 132 and the third meta-region 133. For example, in the second meta-region 132 and the third meta-region 133, the polarization-separating nano-structure p-NP and the polarization-separating sub-nano structures p-sNP may be arranged in a 4-fold symmetry structure. In other words, in the second meta-region 132, the shapes and arrangement of the polarization-separating nano-structure p-NP and the polarization-separating sub-nano structures p-sNP may be mirror-symmetrical in the first direction, the second direction, and two diagonal directions based on the center of the second meta-region 132. In the third meta-region 133, the shapes and arrangement of the polarization-separating nano-structure p-NP and the polarization-separating sub-nano structures p-sNP may be mirror-symmetrical in the first direction, the second direction, and two diagonal directions based on the center of the third meta-region 133.

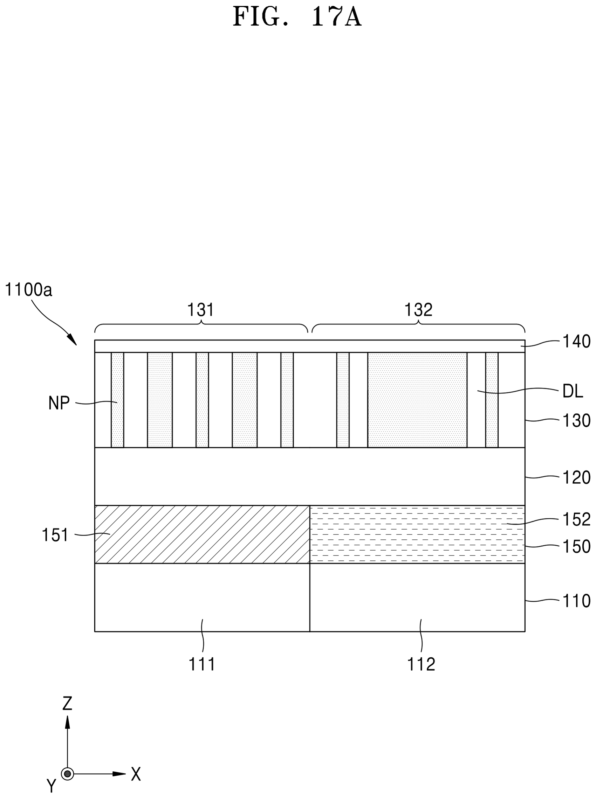

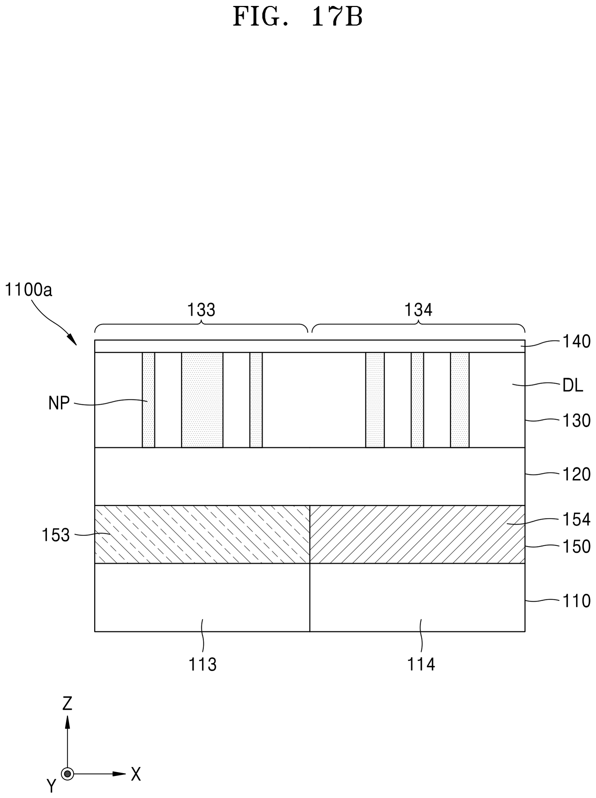

FIGS. 17A and 17B are cross-sectional views schematically showing a structure of a pixel array in the image sensor 1000 according to another embodiment. FIG. 17A shows a cross-section of a pixel array 1100a taken along the first direction, and FIG. 17B shows a cross-section of the pixel array 1100a taken along the first direction at a differently located position from that of FIG. 17A in the second direction that perpendicularly crosses the first direction. Referring to FIGS. 17A and 17B, the pixel array 1100a may further include a color filter layer 150 provided between the sensor substrate 110 and the spacer layer 120. By using the color filter layer 150, the color purity of the image sensor 1000 may be further improved. Also, because the light that is color-separated to a certain degree by the nano-photonic lens array 130 is incident on the color filter layer 150, the light loss due to the color filter layer 150 may not be large.

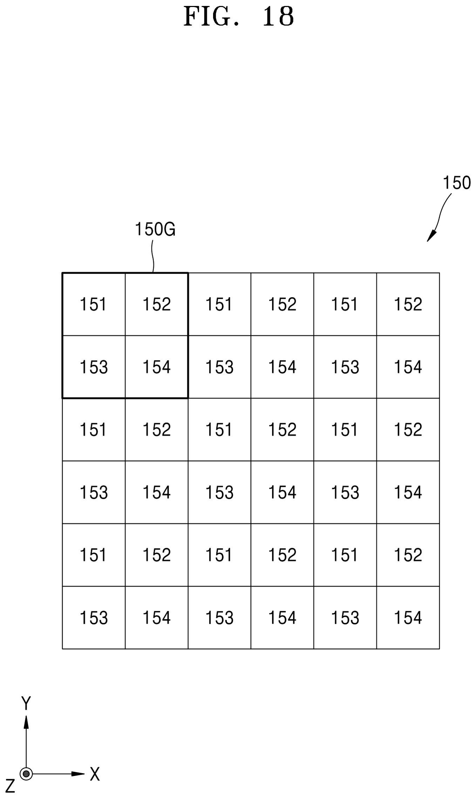

FIG. 18 shows an example of a color filter arrangement in the color filter layer 150 according to an embodiment. Referring to FIG. 18, the color filter layer 150 may include a plurality of unit filter group 150G that are two-dimensionally arranged in the first direction and the second direction. Each of the unit filter groups 150G may include a plurality of color filters that are disposed between the sensor substrate 110 and the nano-photonic lens array 130 to transmit light of a certain wavelength band and absorb light of another wavelength band. For example, each of the unit filter groups 150G may include a first color filter 151 that transmits light of a first wavelength band and absorbs light of another wavelength band, a second color filter 152 that transmits light of a second wavelength band that is different from the first wavelength band and absorbs light of another wavelength band, a third color filter 153 that transmits light of a third wavelength band that is different from the first and second wavelength bands and absorbs light of another wavelength band, and a fourth color filter 154 that transmits light of the first wavelength band and absorbs light of another wavelength band. The first to fourth color filters 151, 152, 153, and 154 may be grouped and two-dimensionally arranged in a 2x2 array in the first and second directions. For example, the first color filter 151 may come into contact with the second color filter 152 in the first direction and may come into contact with the third color filter 153 in the second direction. The second color filter 152 may be in contact with the fourth color filter 154 in the second direction and the third color filter 153 may be in contact with the fourth color filter 154 in the first direction.

In one row on the color filter layer 150, a plurality of first color filters 151 and a plurality of second color filter 152 are alternately arranged in the first direction, and a plurality of third color filters 153 and a plurality of fourth color filters 154 may be alternately arranged in the first direction in one row differently located in the second direction. Also, the plurality of first color filters 151 and the plurality of fourth color filters 154 may be alternately arranged in the first diagonal direction, and the plurality of second color filters 152 and the plurality of third color filters 153 may be alternately arranged in the second diagonal direction crossing the first diagonal direction.

The first color filter 151 may be arranged to face the first pixel 111 and the first meta-region 131 in the third direction, the second color filter 152 may be arranged to face the second pixel 112 and the second meta-region 132 in the third direction, the third color filter 153 may be arranged to face the third pixel 113 and the third meta-region 133 in the third direction, and the fourth color filter 154 may be arranged to face the fourth pixel 114 and the fourth meta-region 134 in the third direction. Accordingly, the first pixel 111 may sense the light of the first wavelength band that passed through the first color filter 151. The second pixel 112 may sense the light of the second wavelength band that passed through the second color filter 152, the third pixel 113 may sense the light of the third wavelength band that passed through the third color filter 153, and the fourth pixel 114 may sense the light of the first wavelength band that passed through the fourth color filter 154.

For example, the first color filter 151 and the fourth color filter 154 may be green color filters transmitting the green light, the second color filter 152 may be a red color filter transmitting the red light, and the third color filter 153 may be a blue color filter transmitting the blue light. In another example, the first color filter 151 and the fourth color filter 154 may be yellow color filters transmitting yellow-based light, the second color filter 151 may be a red color filter, and the third color filter 153 may be a blue color filter. In another example, the first color filter 151 and the fourth color filter 154 may be yellow color filters, the second color filter 152 may be a magenta color filter, and the third color filter 153 may be a cyan color filter.

The first to fourth color filters 151, 152, 153, and 154 in the color filter layer 150 may be formed of, for example, an organic polymer material. For example, the first to fourth color filters 151, 152, 153, and 154 may include a coloring agent, binder resin, polymer photoresist, etc. The first and fourth color filters 151 and 154 may be organic color filters including green organic dye or a green organic pigment as a coloring agent, the second color filter 152 may be an organic color filter including a red organic dye or a red organic pigment as a coloring agent, and the third color filter 153 may be an organic color filter including a blue organic dye or a blue organic pigment as a coloring agent. Although not shown in FIGS. 17A, 17B, and 18 for convenience's sake, the color filter layer 150 may further include a black matrix provided at boundaries among the first to fourth color filters 151, 152, 153, and 154. The black matrix may include, for example, carbon black.

Referring back to FIGS. 17A and 17B, the spacer layer 120 provided on the color filter layer 150 may provide a flat surface for forming the nano-photonic lens array 130 thereon. According to the embodiment, the spacer layer 120 may include an organic polymer material that is suitable for being stacked on the color filter layer 150 that is formed of an organic material and may easily form a flat surface. The organic polymer material forming the spacer layer 120 may be transparent with respect to visible light. For example, the spacer layer 120 may include at least one organic polymer material from an epoxy resin, polyimide, polycarbonate, polyacrylate, and polymethyl methacrylate (PMMA). The spacer layer 120 may be formed on the color filter layer 150 by, for example, a spin coating method, and may have a flat upper surface through a thermal treatment.

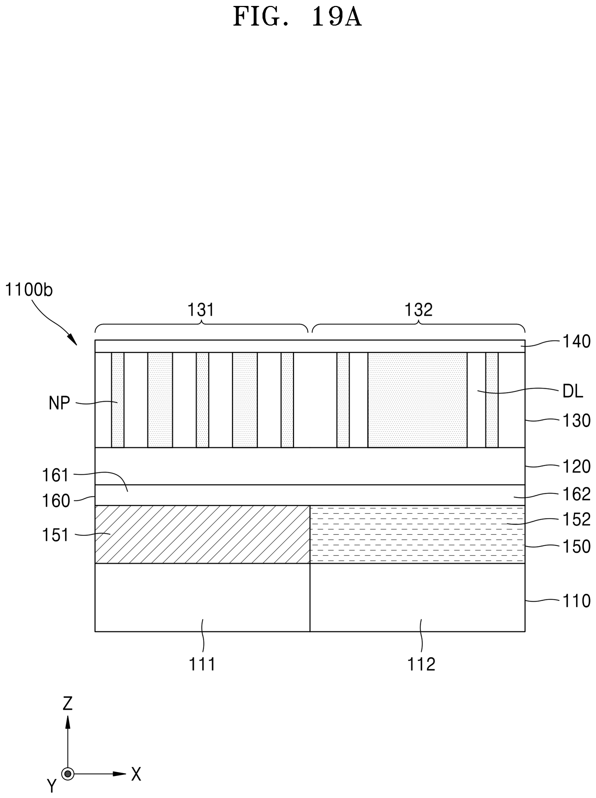

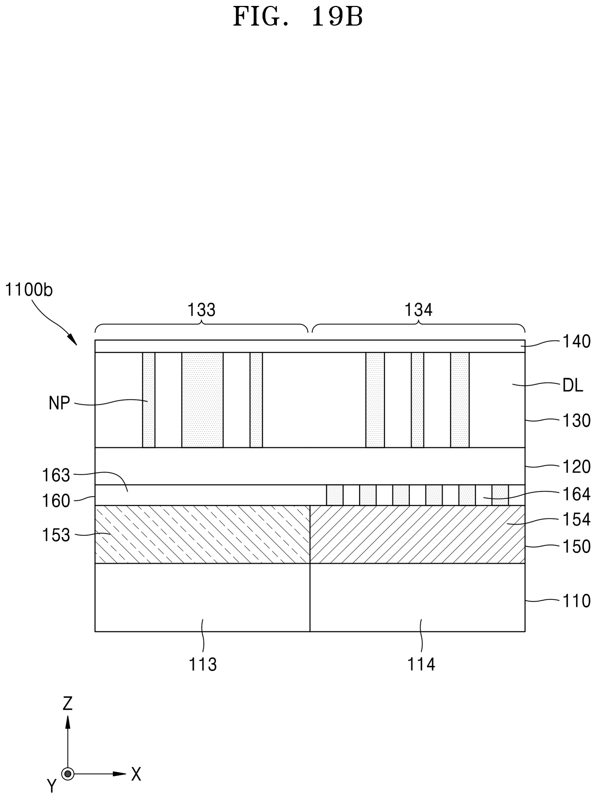

FIGS. 19A and 19B are cross-sectional views schematically showing a structure of a pixel array in an image sensor according to another embodiment. FIG. 19A shows a cross-section of a pixel array 1100b taken along the first direction, and FIG. 19B shows a cross-section of the pixel array 1100b taken along the first direction at a differently located position from that of FIG. 19A in the second direction that perpendicularly crosses the first direction. Referring to FIGS. 19A and 19B, the pixel array 1100b may further include a polarization-separating layer 160 provided between the sensor substrate 110 and the nano-photonic lens array 130, and in particular, the color filter layer 150 and the spacer layer 120. FIGS. 19A and 19B show that the polarization-separating layer 160 is in direct contact with the color filter layer 150, but are not limited thereto. The polarization-separating layer 160 may be embedded in the spacer layer 120. For example, a part of the spacer layer 120 may be provided on the color filter layer 150, the polarization-separating layer 160 is provided thereon, and then, the remaining part of the spacer layer 120 may be provided on the polarization-separating layer 160.

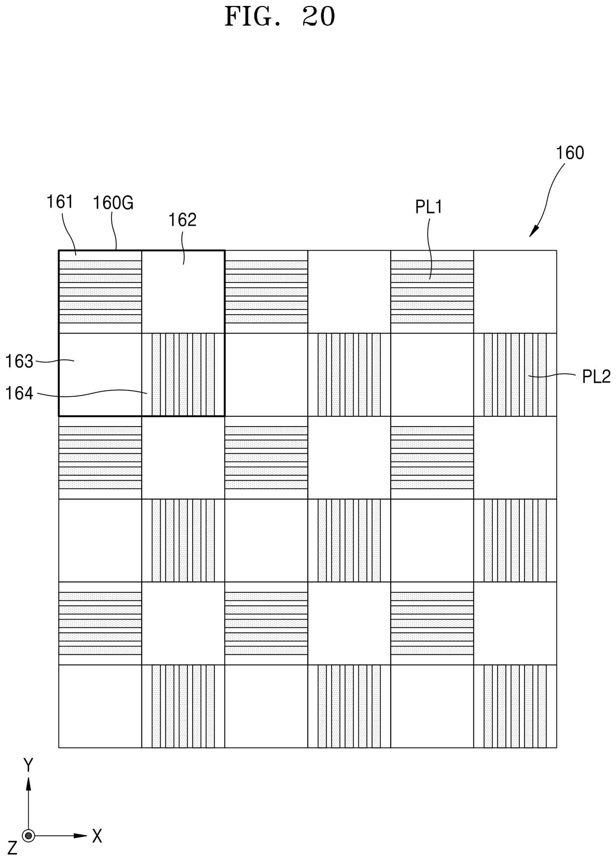

FIG. 20 shows an example of an arrangement of polarization-separating regions in the polarization-separating layer 160 according to an embodiment. Referring to FIG. 20, the polarization-separating layer 160 may include a plurality of unit polarization-separating groups 160G that are two-dimensionally arranged in the first direction and the second direction. Each of the unit polarization-separating groups 160G may include a plurality of polarization-separating regions. For example, each of the unit polarization-separating groups 160G may include a first polarization-separating region 161, a second polarization-separating region 162, a third polarization-separating region 163, and a fourth polarization-separating region 164. The first polarization-separating region 161, the second polarization-separating region 162, the third polarization-separating region 163, and the fourth polarization-separating region 164 may be grouped and two-dimensionally arranged in a 2x2 array in the first direction and the second direction. For example, the first polarization-separating region 161 may be in contact with the second polarization-separating region 162 in the first direction and in contact with the third polarization-separating region 163 in the second direction. The second polarization-separating region 162 may be in contact with the fourth polarization-separating region 164 in the second direction, and the third polarization-separating region 163 may be in contact with the fourth polarization-separating region 164 in the first direction.

In one row of the polarization-separating layer 160, a plurality of first polarization-separating regions 161 and a plurality of second polarization-separating regions 162 may be alternately arranged in the first direction, and in another row differently located in the second direction, a plurality of third polarization-separating regions 163 and a plurality of fourth polarization-separating regions 164 may be alternately arranged in the first direction. Also, the plurality of first polarization-separating regions 161 and the plurality of fourth polarization-separating regions 164 may be alternately arranged in a first diagonal direction, and the plurality of second polarization-separating regions 162 and the plurality of third polarization-separating regions 163 may be alternately arranged in a second diagonal direction crossing the first diagonal direction.

The first polarization-separating region 161 may be arranged to face the first pixel 111, the first color filter 151, and the first meta-region 131 in the third direction, the second polarization-separating region 162 may be arranged to face the second pixel 112, the second color filter 152, and the second meta-region 132 in the third direction, the third polarization-separating region 163 may be arranged to face the third pixel 113, the third color filter 153, and the third meta-region 133 in the third direction, and the fourth polarization-separating region 164 may be arranged to face the fourth pixel 114, the fourth color filter 154, and the fourth meta-region 134 in the third direction.

When the nano-photonic lens array 130 is configured to condense the light of the first wavelength having the first polarization component onto the first pixel 111 and condense the light of the first wavelength having the second polarization component onto the fourth pixel 114, the first polarization-separating region 161 may include a first polarizer PL1 transmitting the light of the first polarization component and reflecting or absorbing the light of the second polarization component. The fourth polarization-separating region 164 may include a second polarizer PL2 transmitting the light of the second polarization component and reflecting or absorbing the light of the first polarization component. The first polarizer PL1 and the second polarizer PL2 may be, for example, wire grid polarizers including a plurality of metal wires parallel to each other, but are not limited thereto. In the first and second polarizers PL1 and PL2, there may be empty spaces among the plurality of metal wires, or a material having transmittance with respect to the visible light may fill among the plurality of metal wires. For example, a material that is the same as that of the spacer layer 120 may be filled between the plurality of metal wires of the first and second polarizers PL1 and PL2.

In another example, when the nano-photonic lens array 130 is configured to condense the light of the first wavelength having the second polarization component onto the first pixel 111 and condense the light of the first wavelength having the first polarization component onto the fourth pixel 114, the first polarization-separating region 161 may include the second polarizer PL2 transmitting the light of the second polarization component and reflecting or absorbing the light of the first polarization component. The fourth polarization-separating region 164 may include the first polarizer PL1 transmitting the light of the first polarization component and reflecting or absorbing the light of the second polarization component.

The second polarization-separating region 162 and the third polarization-separating region 163 may not include a polarizer. The second polarization-separating region 162 and the third polarization-separating region 163 may include empty spaces, or may be filled with a material having transmittance with respect to the visible light. For example, the second polarization-separating region 162 and the third polarization-separating region 163 may be filled with the same material as that of the spacer layer 120. Therefore, the second polarization-separating region 162 and the third polarization-separating region 163 may be configured to transmit the light of all polarization components.

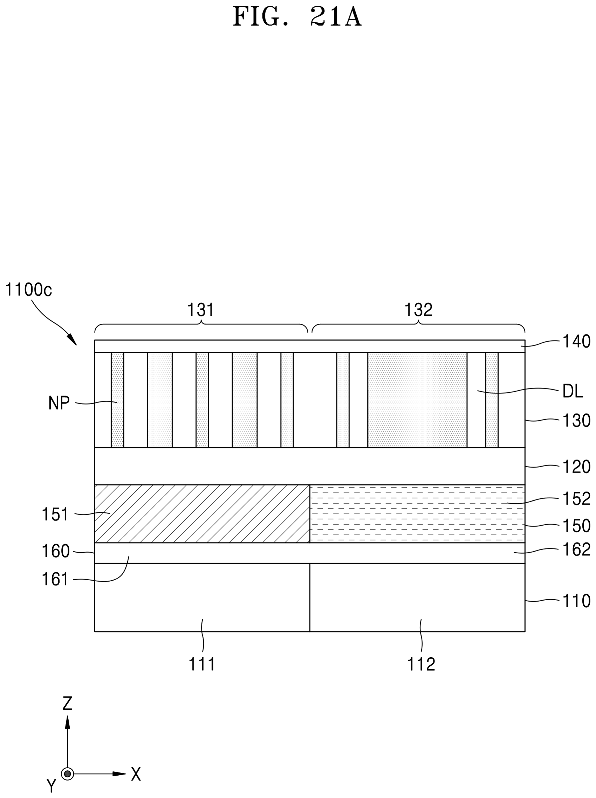

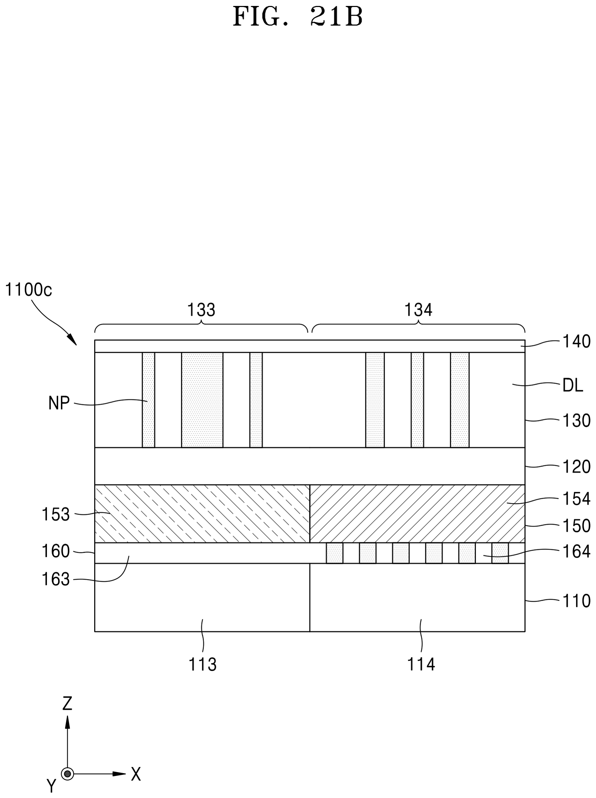

FIGS. 21A and 21B are cross-sectional views schematically showing a structure of a pixel array in the image sensor 1000 according to another embodiment. FIG. 21A shows a cross-section of a pixel array 1100c taken along the first direction, and FIG. 21B shows a cross-section of the pixel array 1100c taken along the first direction at a different location from that of the cross-section shown in FIG. 21A. FIGS. 19A and 19B illustrate that the polarization-separating layer 160 is provided between the color filter layer 150 and the spacer layer 120, but the location of the polarization-separating layer 160 is not limited thereto. Referring to FIGS. 21A and 21B, the pixel array 1100c may include the polarization-separating layer 160 provided between the sensor substrate 110 and the color filter layer 150. The polarization-separating layer 160 may have the same configurations as described with reference to FIG. 20.

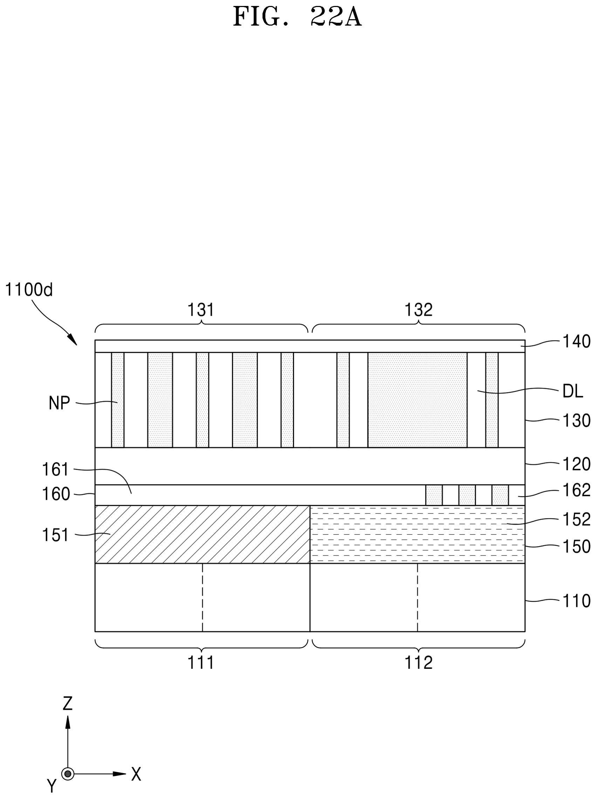

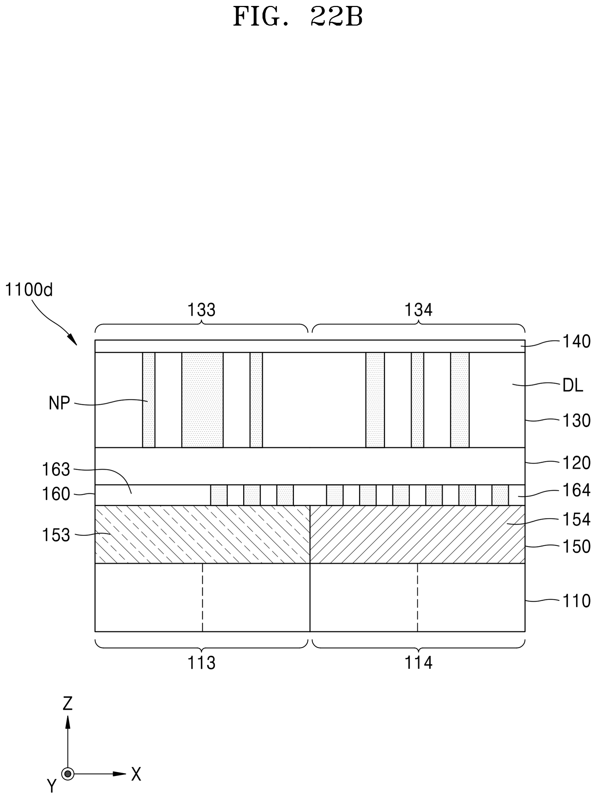

FIGS. 22A and 22B are cross-sectional views schematically showing a structure of a pixel array in the image sensor 1000 according to another embodiment. FIG. 22A shows a cross-section of a pixel array 1100d taken along the first direction, and FIG. 22B shows a cross-section of the pixel array 1100d taken along the first direction at a different location from that of the cross-section shown in FIG. 22A in the second direction. Referring to FIGS. 22A and 22B, each pixel in the sensor substrate 110 of the pixel array 1100d may include a plurality of sub-pixels independently sensing light.

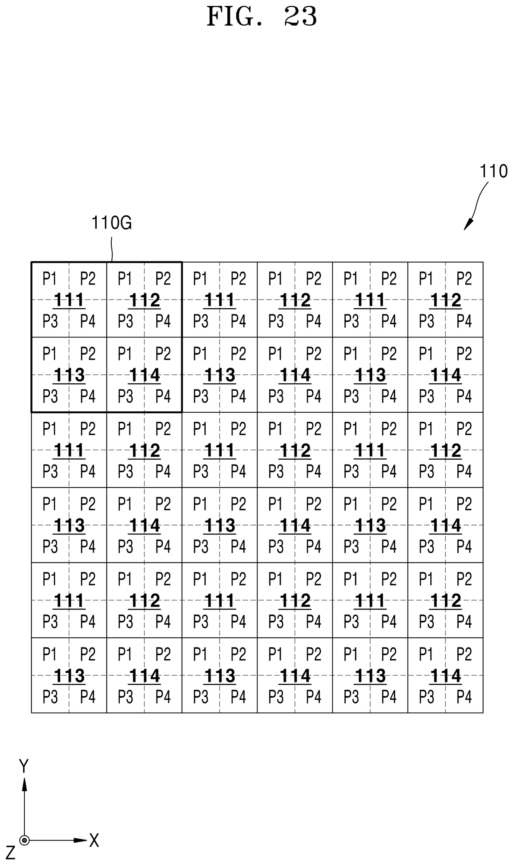

FIG. 23 shows an example of a pixel arrangement in the sensor substrate 110 shown in FIGS. 22A and 22B. Referring to FIG. 23, each of the first pixel 111, the second pixel 112, the third pixel 113, and the fourth pixel 114 may include the sub-pixels that are grouped and two-dimensionally arranged in a 2x2 array in the first and second directions. For example, the first pixel 111 may include a first sub-pixel P1, a second sub-pixel P2, a third sub-pixel P3, and a fourth sub-pixel P4 that are grouped and two-dimensionally arranged in a 2x2 array in the first and second directions. The first sub-pixel P1 may be in contact with the second sub-pixel P2 in the first direction and may be in contact with the third sub-pixel P3 in the second direction. The second sub-pixel P2 may be in contact with the fourth sub-pixel P4 in the second direction and the third sub-pixel P3 may be in contact with the fourth sub-pixel P4 in the first direction. Likewise, each of the second pixel 112, the third pixel 113, and the fourth pixel 114 may include the first sub-pixel P1, the second sub-pixel P2, the third sub-pixel P3, and the fourth sub-pixel P4.

Each of the first sub-pixel P1, the second sub-pixel P2, the third sub-pixel P3, and the fourth sub-pixel P4 in each of the first pixel 111, the second pixel 112, the third pixel 113, and the fourth pixel 114 may independently sense incident light. Then, color images may be obtained in two different ways. First, in an example, each of the first sub-pixel P1, the second sub-pixel P2, the third sub-pixel P3, and the fourth sub-pixel P4 may operate as one independent channel. In this case, each of the first pixel 111, the second pixel 112, the third pixel 113, and the fourth pixel 114 has four independent channels, and one unit pixel group 110G may output sixteen independent signals. For example, the first pixel 111 may include four independent green channels, the second pixel 112 may include four independent red channels, the third pixel 113 may include four independent blue channels, and the fourth pixel 114 may include four independent green channels. In the image signal processing process, a processor individually uses signals output from the first sub-pixel P1, the second sub-pixel P2, the third sub-pixel P3, and the fourth sub-pixel P4, for example, may perform operations such as noise reduction, color correction, etc. and generate the color images. In an example, the processor may be included in the image sensor 1000, or may be a component included in an electronic device including the image sensor 1000.

In another example, a binning mode operation may be performed for increasing sensitivity in a low illuminance environment. The binning mode is an image processing method which sums outputs from the first sub-pixel P1, the second sub-pixel P2, the third sub-pixel P3, and the fourth sub-pixel P4. For example, output signals from the first sub-pixel P1, the second sub-pixel P2, the third sub-pixel P3, and the fourth sub-pixel P4 of the first pixel 111 are summed to generate a first green image signal, output signals from the first sub-pixel P1, the second sub-pixel P2, the third sub-pixel P3, and the fourth sub-pixel P4 of the second pixel 112 are summed to generate a red image signal, output signals from the first sub-pixel P1, the second sub-pixel P2, the third sub-pixel P3, and the fourth sub-pixel P4 of the third pixel 113 are summed to generate a blue image signal, and output signals from the first sub-pixel P1, the second sub-pixel P2, the third sub-pixel P3, and the fourth sub-pixel P4 of the fourth pixel 114 are summed to generate a second green image signal. The processor may be configured to perform an image signal process on the summed image signals and to generate the color image.

In the high illuminance environment, the first sub-pixel P1, the second sub-pixel P2, the third sub-pixel P3, and the fourth sub-pixel P4 of the first pixel 111 may individually output first green image signals. Therefore, the first pixel 111 may output four first green image signals having different spatial information. Likewise, the second pixel 112 may output four red image signals having different spatial information respectively from the first sub-pixel P1, the second sub-pixel P2, the third sub-pixel P3, and the fourth sub-pixel P4, the third pixel 113 may output four blue image signals having different spatial information respectively from the first sub-pixel P1, the second sub-pixel P2, the third sub-pixel P3, and the fourth sub-pixel P4, and the fourth pixel 114 may output four second green image signals having different spatial information respectively from the first sub-pixel P1, the second sub-pixel P2, the third sub-pixel P3, and the fourth sub-pixel P4.

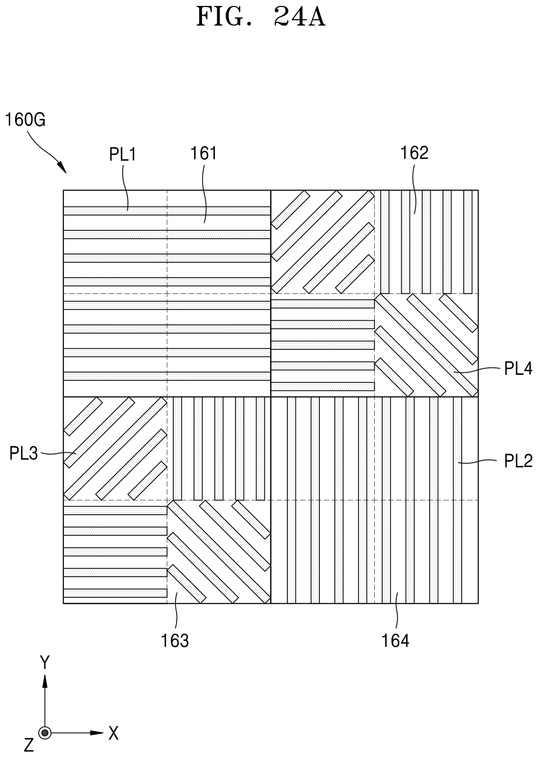

In the example shown in FIGS. 22A and 22B, the polarization-separating layer 160 of the pixel array 1100d may be configured to provide the light of different polarization components to the sub-pixels of the second pixel 112 and the sub-pixels of the third pixel 113. FIG. 24A shows an example arrangement of unit polarization-separating group in a polarization-separating layer 160 according to some embodiments.

Referring to FIG. 24A, the first polarization-separating region 161 may include the first polarizer PL1 and the fourth polarization-separating region 164 may include the second polarizer PL2. The first polarizer PL1 of the first polarization-separating region 161 may face all of the first sub-pixel P1, the second sub-pixel P2, the third sub-pixel P3, and the fourth sub-pixel P4 of the first pixel 111. The second polarizer PL2 of the fourth polarization-separating region 164 may face all of the first sub-pixel P1, the second sub-pixel P2, the third sub-pixel P3, and the fourth sub-pixel P4 of the fourth pixel 114.

The second polarization-separating region 162 and the third polarization-separating region 163 may include the first polarizer PL1, the second polarizer PL2, a third polarizer PL3 transmitting the light of the third polarization component (e.g., linear polarization component in 45-degree direction) in the different direction from the first polarization component and the second polarization component, and a fourth polarizer PL4 transmitting the light of a fourth polarization component in a different direction from the first to third polarization components (e.g., linear polarization component in 135-degree direction). For example, in the second polarization-separating region 162, the first polarizer PL1 may face the third sub-pixel P3 of the second pixel 112, the second polarizer PL2 may face the second sub-pixel P2 of the second pixel 112, the third polarizer PL3 may face the first sub-pixel P1 of the second pixel 112, and the fourth polarizer PL4 may face the fourth sub-pixel P4 of the second pixel 112. In the third polarization-separating region 163, the first polarizer PL1 may face the third sub-pixel P3 of the third pixel 113, the second polarizer PL2 may face the second sub-pixel P2 of the third pixel 113, the third polarizer PL3 may face the first sub-pixel P1 of the third pixel 113, and the fourth polarizer PL4 may face the fourth sub-pixel P4 of the third pixel 113.

In this case, the first sub-pixel P1 of the second pixel 112 may sense the light of the second wavelength having the third polarization component, the second sub-pixel P2 of the second pixel 112 may sense the light of the second wavelength having the second polarization component, the third sub-pixel P3 of the second pixel 112 may sense the light of the second wavelength having the first polarization component, and the fourth sub-pixel P4 of the second pixel 112 may sense the light of the second wavelength having the fourth polarization component. The first sub-pixel P1 of the third pixel 113 may sense the light of the third wavelength having the third polarization component, the second sub-pixel P2 of the third pixel 113 may sense the light of the third wavelength having the second polarization component, the third sub-pixel P3 of the third pixel 113 may sense the light of the third wavelength having the first polarization component, and the fourth sub-pixel P4 of the third pixel 113 may sense the light of the third wavelength having the fourth polarization component.

However, in the second polarization-separating region 162 and the third polarization-separating region 163, the arrangement of the first polarizer PL1, the second polarizer PL2, the third polarizer PL3, and the fourth polarizer PL4 is not limited to the example of FIG. 24A, and locations of the first polarizer PL1, the second polarizer PL2, the third polarizer PL3, and the fourth polarizer PL4 may be differently selected depending on the necessity in designing the image sensor 1000. In other words, the first polarizer PL1, the second polarizer PL2, the third polarizer PL3, and the fourth polarizer PL4 of the second polarization-separating region 162 may be provided to each face one of the first to fourth sub-pixels P1, P2, P3, and P4 of the second pixel 112, and the first polarizer PL1, the second polarizer PL2, the third polarizer PL3, and the fourth polarizer PL4 of the third polarization-separating region 163 may be provided to each face one of the first to fourth sub-pixels P1, P2, P3, and P4 of the third pixel 113.

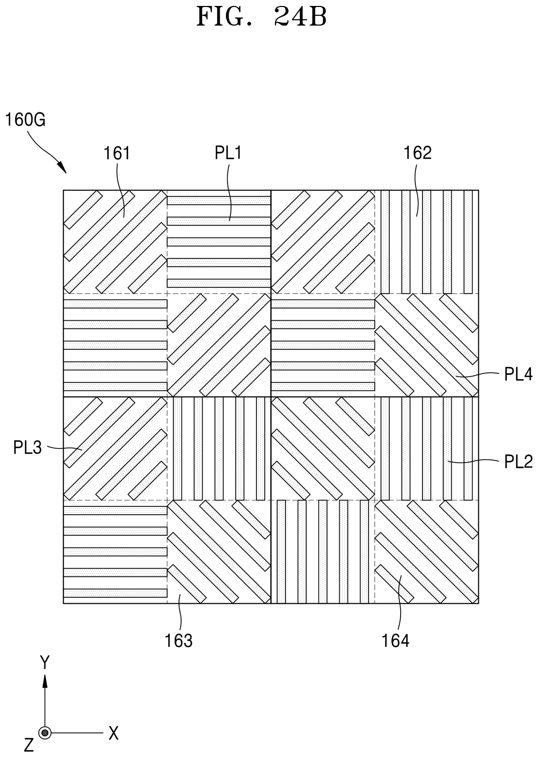

FIG. 24B shows an example arrangement of unit polarization-separating group in a polarization-separating layer 160 according to some embodiments. As described above with reference to FIG. 15, the light of the first polarization component and the light of the second polarization component may not be completely separated. This may be caused by the existence of the third polarization component and the fourth polarization component in the diagonal directions. Considering this, like the second polarization-separating region 162 and the third polarization-separating region 163, the first polarization-separating region 161 and the fourth polarization-separating region 164 may also include at least one of the third polarizer PL3 and the fourth polarizer PL4.

For example, the first polarization-separating region 161 may include two first polarizers PL1 respectively facing the second sub-pixel P2 and the third sub-pixel P3 of the first pixel 111, and two third polarizer PL3 respectively facing the first sub-pixel P1 and the fourth sub-pixel P4 of the first pixel 111. Then, the second sub-pixel P2 and the third sub-pixel P3 of the first pixel 111 may sense the light of the first wavelength having the first polarization component, and the first sub-pixel P1 and the fourth sub-pixel P4 of the first pixel 111 may sense the light of the first wavelength having the third polarization component. The fourth polarization-separating region 164 may include two second polarizers PL2 respectively facing the second sub-pixel P2 and the third sub-pixel P3 of the fourth pixel 114, and two fourth polarizer PL4 respectively facing the first sub-pixel P1 and the fourth sub-pixel P4 of the fourth pixel 114. Then, the second sub-pixel P2 and the third sub-pixel P3 of the fourth pixel 114 may sense the light of the first wavelength having the second polarization component, and the first sub-pixel P1 and the fourth sub-pixel P4 of the fourth pixel 114 may sense the light of the first wavelength having the fourth polarization component.

FIG. 24B shows that the first polarization-separating region 161 includes the first polarizer PL1 and the third polarizer PL3, and the fourth polarization-separating region 164 includes the second polarizer PL2 and the fourth polarizer PL4, but is not limited thereto. For example, the first polarization-separating region 161 may include two first polarizers PL1 and two fourth polarizer PL4, and the fourth polarization-separating region 164 may include two second polarizers PL2 and two third polarizers PL3. In other example, the first polarization-separating region 161 may include two first polarizers PL1, one third polarizer PL3, and one fourth polarizer PL4, and the fourth polarization-separating region 164 may include two second polarizer PL2, one third polarizer PL3, and one fourth polarizer PL4. Also, in the first polarization-separating region 161 and the fourth polarization-separating region 164, the locations of the first polarizer PL1, the second polarizer PL2, the third polarizer PL3, and the fourth polarizer PL4 are not limited to the example shown in FIG. 24B, and may be differently selected depending on the necessity in designing the image sensor 1000.

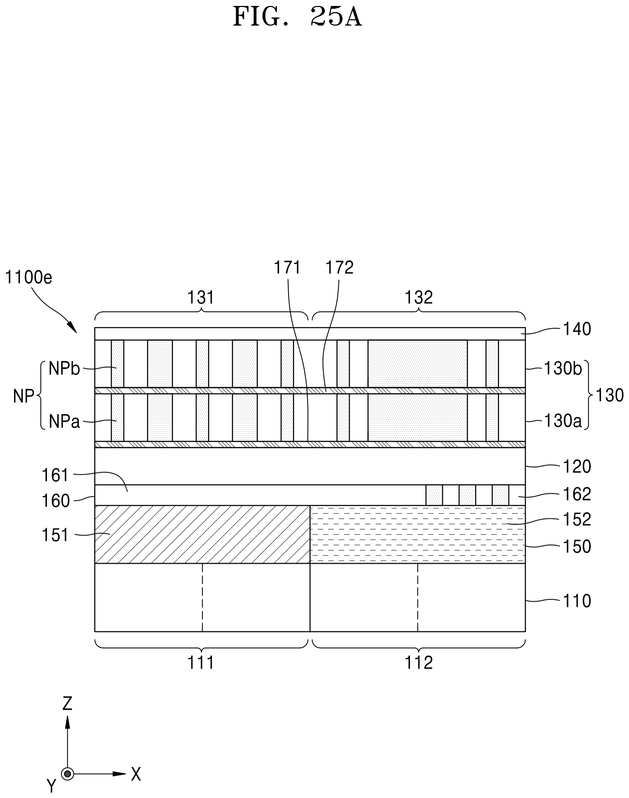

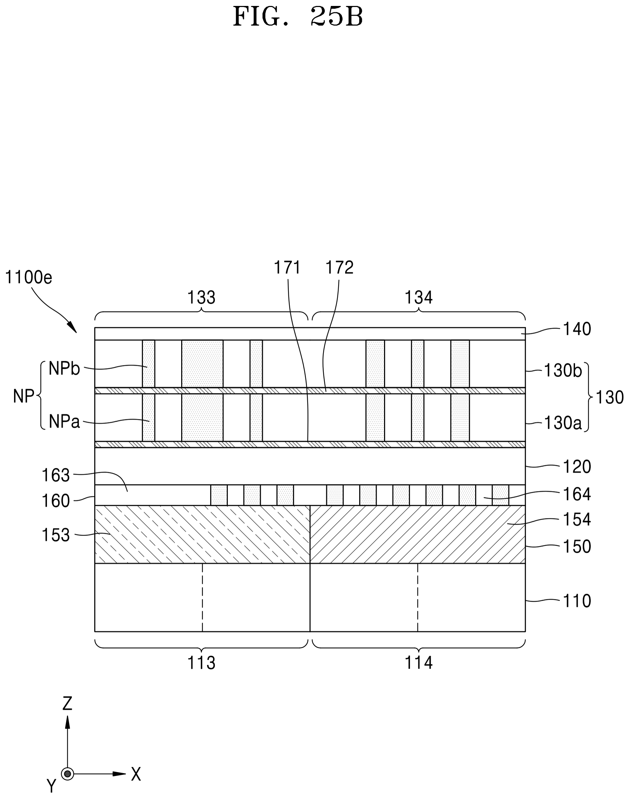

FIGS. 25A and 25B are cross-sectional views schematically showing a structure of a pixel array in the image sensor 1000 according to another embodiment. FIG. 25A shows a cross-section of a pixel array 1100e taken along the first direction, and FIG. 25B shows a cross-section of the pixel array 1100e taken along the first direction at a different location from that of the cross-section shown in FIG. 25A in the second direction. Referring to FIGS. 25A and 25B, the nano-photonic lens array 130 of the pixel array 1100e may have two or more multi-layered structure.

For example, the nano-photonic lens array 130 may include a first nano-photonic lens array layer 130a provided on the spacer layer 120, and a second nano-photonic lens array layer 130b provided on the first nano-photonic lens array layer 130a. The first nano-photonic lens array layer 130a may include a plurality of first nano-structures NPa, and the second nano-photonic lens array layer 130b may include a plurality of second nano-structures NPb. The arrangement type of the plurality of first nano-structures NPa in the first nano-photonic lens array layer 130a and the arrangement type of the plurality of second nano-structures NPb in the second nano-photonic lens array layer 130b may be the same as or different from each other. The polarization-separating nano-structures p-NP described above may be provided in both of the first nano-photonic lens array layer 130a and the second nano-photonic lens array layer 130b, or may be provided in any one of the first nano-photonic lens array layer 130a and the second nano-photonic lens array layer 130b.

Also, the pixel array 1100e may further include a first etch-stop layer 171 provided between the spacer layer 120 and the first nano-photonic lens array layer 130a, and a second etch-stop layer 172 provided between the first nano-photonic lens array layer 130a and the second nano-photonic lens array layer 130b. The first etch-stop layer 171 may prevent the spacer layer 120 from being etched and damaged during the process of forming the first nano-photonic lens array layer 130a on the spacer layer 120. The second etch-stop layer 172 may prevent the first nano-photonic lens array layer 130a from being etched and damaged during the process of forming the second nano-photonic lens array layer 130b. The first and second etch-stop layers 171 and 172 may include, for example, at least one material selected from aluminum oxide (AIO), hafnium oxide (HfO), and silicon nitride (SiN).

The image sensor 1000 according to the embodiment may form a camera module along with a module lens of various functions and may be utilized in various electronic devicees.

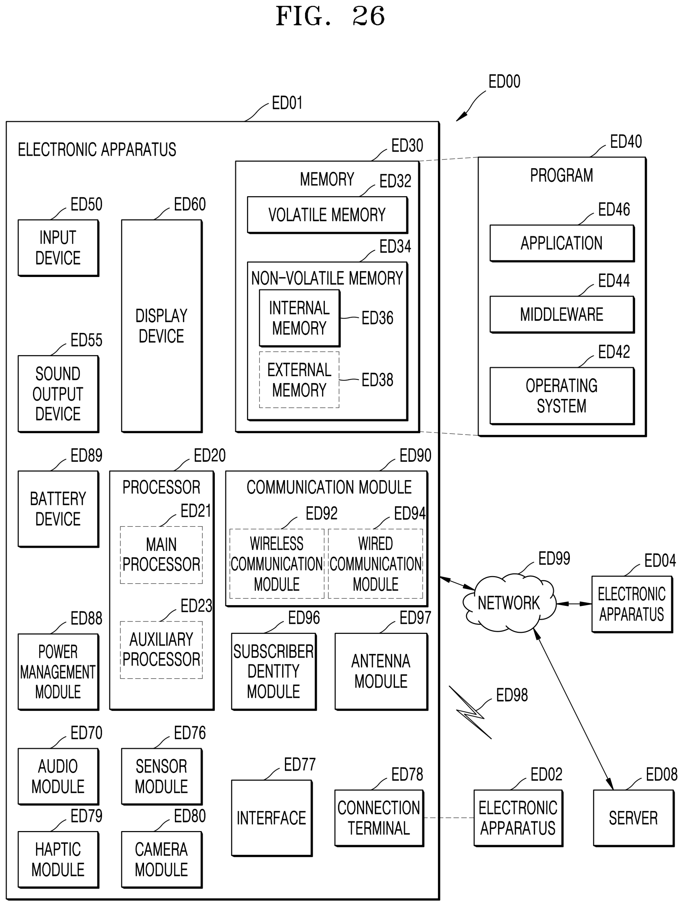

FIG. 26 is a block diagram showing an example of an electronic device ED01 including an image sensor 1000. Referring to FIG. 26, in a network environment ED00, the electronic device ED01 may communicate with another electronic device ED02 via a first network ED98 (short-range wireless communication network, etc.), or may communicate with another electronic device ED04 and/or a server ED08 via a second network ED99 (long-range wireless communication network, etc.). The electronic device ED01 may communicate with the electronic device ED04 via the server ED08. The electronic device ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic device ED01, some (the display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic device ED01 connected to the processor ED20 by executing software (program ED40, etc.) and may perform various data processing or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 a (central processing unit, an application processor, etc.) and an auxiliary processor ED23 (a graphics processing unit, an image signal processor, a sensor hub processor, a communication processor, etc.) that may operate independently from or along with the main processor ED21. The auxiliary processor ED23 may use less power than that of the main processor ED21 and may perform specific functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (the display device ED60, the sensor module ED76, the communication module ED90, etc.) of the elements in the electronic device ED01. The auxiliary processor ED23 (an image signal processor, a communication processor, etc.) may be implemented as a part of another element (the camera module ED80, the communication module ED90, etc.) that is functionally related thereto.

The memory ED30 may store various data required by the elements (the processor ED20, the sensor module ED76, etc.) of the electronic device ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30 and may include an operation system ED42, middleware ED44, and/or an application ED46.

The input device ED50 may receive commands and/or data to be used in the elements (the processor ED20, etc.) of the electronic device ED01, from outside (a user, etc.) of the electronic device ED01. The input device ED50 may include a microphone, a mouse, a keyboard, and/or a digital pen (stylus pen).

The sound output device ED55 may output a sound signal to outside of the electronic device ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic device ED01. The display device ED60 may include a display, a hologram device, or a projector, and a control circuit for controlling the corresponding device. The display device ED60 may include touch circuitry set to sense a touch, and/or a sensor circuit (pressure sensor, etc.) that is set to measure the strength of a force generated by the touch.

The audio module ED70 may convert sound into an electrical signal or vice versa. The audio module ED 70 may acquire sound through the input device ED50, or may output sound via the sound output device ED55 and/or a speaker and/or headphones of another electronic device (the electronic device ED02, etc.) connected directly or wirelessly to the electronic device ED01.

The sensor module ED76 may sense an operating state (power, temperature, etc.) of the electronic device ED01, or an outer environmental state (user state, etc.) and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic device ED01 to be directly or wirelessly connected to another electronic device (the electronic device ED02, etc.) The interface ED77 may include a high-definition multimedia interface (HDMI), a universal serial bus (USB) interface, an SD card interface, and/or an audio interface.

The connection terminal ED78 may include a connector by which the electronic device ED01 may be physically connected to another electronic device (the electronic device ED02, etc.). The connection terminal ED78 may include an HDMI connector, a USB connector, an SD card connector, and/or an audio connector (headphones connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic device ED01. The power management module ED88 may be implemented as a part of a power management integrated circuit (PMIC).

The battery ED89 may supply electric power to components of the electronic device ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic device ED01 and another electronic device (the electronic device ED02, the electronic device ED04, the server ED08, etc.), and execution of communication through the established communication channel. The communication module ED90 may be operated independently from the processor ED20 (application processor, etc.) and may include one or more communication processors that support the direct communication and/or the wireless communication. The communication module ED90 may include a wireless communication module ED92 (a cellular communication module, a short-range wireless communication module, a global navigation satellite system (GNSS) communication module) and/or a wired communication module ED94 (a local area network (LAN) communication module, a power line communication module, etc.). From among the communication modules, a corresponding communication module may communicate with another electronic device via the first network ED98 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic device ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic device, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic device via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic device ED01 and the external electronic device ED04 via the server ED08 connected to the second network ED99. Other electronic devicees ED02 and ED04 may be the devices that are the same as or different kinds from the electronic device ED01. All or some of the operations executed in the electronic device ED01 may be executed in one or more devices among the other electronic devicees ED02, ED04, and ED08. For example, when the electronic device ED01 has to perform a certain function or service, the electronic device ED01 may request one or more other electronic devicees to perform some or entire function or service, instead of executing the function or service by itself. One or more electronic devicees receiving the request execute an additional function or service related to the request and may transfer a result of the execution to the electronic device ED01. To do this, for example, a cloud computing, a distributed computing, or a client-server computing technique may be used.

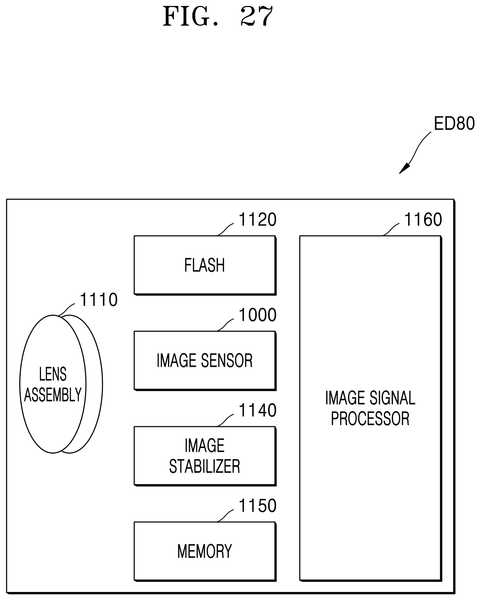

FIG. 27 is a block diagram showing an example of the camera module ED80 included in the electronic device ED01 of FIG. 26. Referring to FIG. 27, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic device ED01 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic device ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic device ED01, or may include an additional memory that is operated independently.

The image signal processor 1160 may perform image processing on the image obtained through the image sensor 1000 or the image data stored in the memory 1150. The image processing may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. Also, the image signal processor 1160 may generate a full-color image by executing demosaic algorithm. For example, when the demosaic algorithm is executed to generate the full-color image, the image signal processor 1160 may reconstruct most of the spatial resolution information by using an image signal of a green channel or yellow channel having high spatial sampling rate.

The image processed by the image signal processor 1160 may be stored again in the memory 1150 for additional process, or may be provided to an external element of the camera module ED80 (e.g., the memory ED30, the display device ED60, the electronic device ED02, the electronic device ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image processing by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic device ED01 may further include one or a plurality of camera modules having different properties or functions. The camera module may include elements similar to those of the camera module ED80 of FIG. 27, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

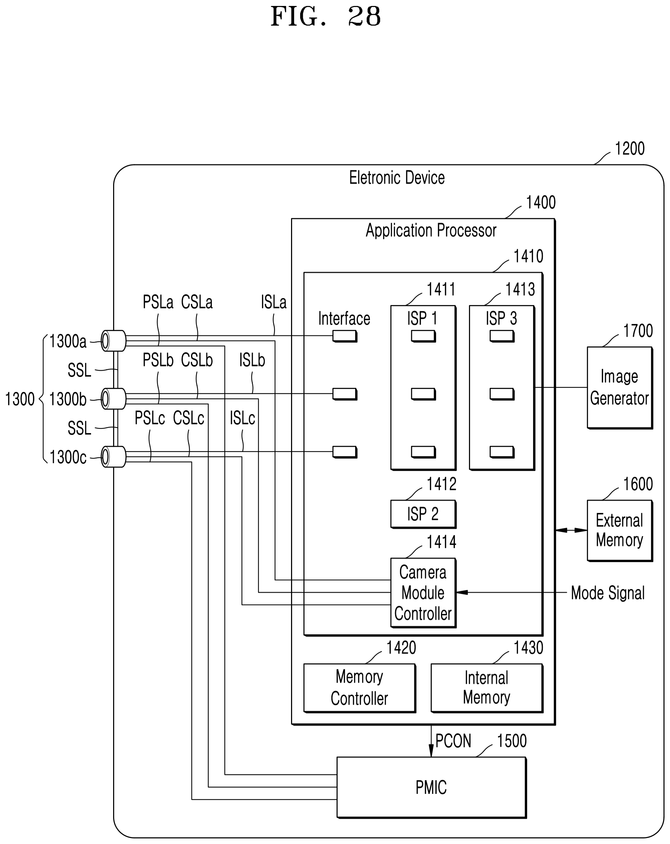

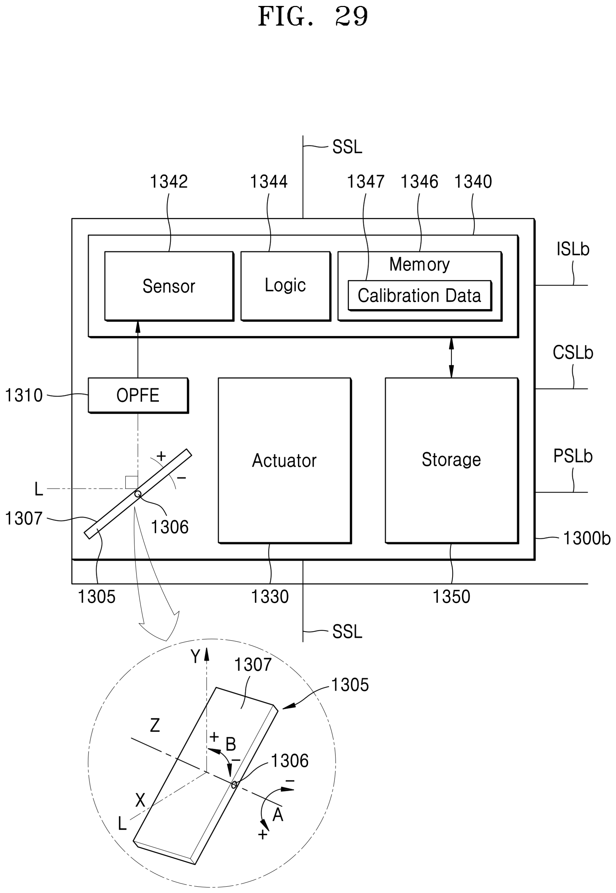

FIG. 28 is a block diagram of an electronic device 1200 including a multi-camera module, and FIG. 29 is a detailed block diagram of the camera module in the electronic device shown in FIG. 28.

Referring to FIG. 28, the electronic device 1200 may include a camera module group 1300, an application processor 1400, a PMIC 1500, an external memory 1600, and an image generator 1700.

The camera module group 1300 may include a plurality of camera modules 1300a, 1300b, and 1300c. Although the drawings show an example in which three camera modules 1300a, 1300b, and 1300c are arranged, one or more embodiments are not limited thereto. In some embodiments, the camera module group 1300 may be modified to include only two camera modules. Also, in some embodiments, the camera module group 1300 may be modified to include n (n is 4 or greater natural number) camera modules.

Hereinafter, detailed configuration of one camera module 1300b is described in detail below with reference to FIG. 29, but the description provided below may be also applied to the other camera modules 1300a and 1300c according to the embodiments.

Referring to FIG. 29, the camera module 1300b may include a prism 1305, an optical path folding element (OPFE) 1310, an actuator 1330, an image sensing device 1340, and a storage 1350.

The prism 1305 may include a reflecting surface 1307 having a light-reflecting material and may deform a path of light L incident from outside.

In some embodiments, the prism 1305 may change the path of the light L incident in the first direction (X-direction) into a second direction (Y-direction) that perpendicularly crosses the first direction (X-direction). Also, the prism 1305 may rotate the reflecting surface 1307 having the light-reflecting material about a center axis 1306 in a direction A, or about the center axis 1306 in a direction B such that the path of the light L incident in the first direction (X-direction) may be changed to the second direction (Y-direction) perpendicularly crossing the first direction (X-direction). Here, the OPFE 1310 may also move in the third direction (Z-direction) that perpendicularly crosses the first direction (X-direction) and the second direction (Y-direction).

In some embodiments, as shown in the drawings, the maximum rotation angle of the prism 1305 in the direction A is 15° or less in the positive A direction and is greater than 15° in the negative A direction, but the embodiments are not limited thereto.

In some embodiments, the prism 1305 may be moved by the angle of about 20°, or between 10° to 20° or 15° to 20° in the positive or negative B direction. Here, the moving angle is the same in the positive or negative B direction, or may be similar within a range of about 1°.

In some embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups (here, m is a natural number). Here, m lenses move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 or the optical lens (hereinafter, referred to as optical lens) to a certain position. For example, the actuator 1330 may adjust the position of the optical lens such that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to the above effects, the optical intensity required to generate high quality images of high resolution and under the low illuminance may be secured.

The memory 1346 may store information that is necessary for the operation of the camera module 1300b, e.g., calibration data 1347. The calibration data 1347 may include information that is necessary to generate image data by using the light L provided from outside through the camera module 1300b. The calibration data 1347 may include, for example, information about the degree of rotation described above, information about the focal length, information about an optical axis, etc. When the camera module 1300b is implemented in the form of a multi-state camera of which the focal length is changed according to the position of the optical lens, the calibration data 1347 may include information related to focal length values of the optical lens according to each position (or state) and auto-focusing.

The storage 1350 may store image data sensed through the image sensor 1342. The storage 1350 may be disposed out of the image sensing device 1340 and may be stacked with a sensor chip included in the image sensing device 1340. In some embodiments, the storage 1350 may be implemented as electrically erasable programmable read-only memory (EEPROM), but one or more embodiments are not limited thereto.

Referring to FIGS. 28 and 29, in some embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some embodiments, one (for example, 1300b) of the plurality of camera modules 1300a, 1300b, and 1300c may be a camera module in a folded lens type including the prism 1305 and the OPFE 1310 described above, and the other camera modules (for example, 1300a and 1300c) may be vertical type camera modules not including the prism 1305 and the OPFE 1310. However, the disclosure is not limited thereto.

In some embodiments, one (for example, 1300c) of the plurality of camera modules 1300a, 1300b, and 1300c may be a depth camera of a vertical type, which extracts depth information by using infrared ray (IR).

In some embodiments, at least two camera modules (e.g., 1300a and 1300b) from among the plurality of camera module 1300a, 1300b, and 1300c may have different fields of view. In this case, for example, the optical lenses of the at least two camera modules (e.g., 1300a and 1300b) from among the plurality of camera modules 1300a, 1300b, and 1300c may be different from each other, but one or more embodiments are not limited thereto.

Also, in some embodiments, the plurality of camera modules 1300a, 1300b, and 1300c may have different fields of view from one another. In this case, the optical lenses respectively included in the plurality of camera modules 1300a, 1300b, and 1300c may be different from one another, but the inventive concept is not limited thereto.

In some embodiments, the plurality of camera modules 1300a, 1300b, and 1300c may be physically isolated from one another. That is, the sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 28, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 via separate image signal lines ISLa, ISLb, and ISLc, respectively. The image data transfer may be carried out by using a camera serial interface (CSI) based on a mobile industry processor interface (MIPI), for example, but is not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. When the number of sub-processors is equal to the number of camera modules 1300a, 1300b, and 1300c, each of the sub-processors may process the image data provided from one camera module. When the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1412. The image processor 1412 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

In detail, the image generator 1700 may generate an output image by merging at least parts of the image data generated by the camera modules 1300a, 1300b, and 1300c having different fields of view, according to image generating information or the mode signal. Also, the image generator 1700 may generate the output image by selecting one of pieces of image data generated by the camera modules 1300a, 1300b, and 1300c having different fields of view, according to image generating information or the mode signal.

In some embodiments, the image generating information may include a zoom signal or a zoom factor. Also, in some embodiments, the mode signal may be, for example, a signal based on a mode selected by a user.

When the image generating information is a zoom signal (zoom factor) and the camera modules 1300a, 1300b, and 1300c have different fields of view (angles of view) from one another, the image generator 1700 may perform different operations according to the kind of zoom signal. For example, when the zoom signal is a first signal, the image data output from the camera module 1300a is merged with the image data output from the camera module 1300c, and then, the output image may be generated by using the merged image signal and the image data output from the camera module 1300b and not used in the merge. When the zoom signal is a second signal that is different from the first signal, the image generator 1700 may not perform the image data merging, and then, may generate the output image by selecting one piece of the image data output respectively from the camera modules 1300a, 1300b, and 1300c. However, one or more embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c via control signal lines CSLa, CSLb, and CSLc separated from one another.

In some embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encodes the image signal at a second speed that is faster than the first speed (for example, encoding the image signal of a second frame rate that is greater than the first frame rate), and transfers the encoded image signal to the application processor 1400. Here, the second speed may be 30 times faster than the first speed or less.

The application processor 1400 may store the received image signal, that is, the encoded mage signal, in the internal memory 1430 provided therein or the external memory 1600 outside the application processor 1400, and after that, reads and decodes the encoded signal from the internal memory 1430 or the external memory1600, and may display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c generates an image signal at a third speed that is slower than the first speed (for example, generating the image signal of a third frame rate that is lower than the first frame rate), and may transfer the image signal to the application processor 1400. The image signal provided to the application processor 1400 may be a signal that is not encoded. The application processor 1400 may perform the image processing of the received image signal or store the image signal in the internal memory 1430 or the external memory1600.

The PMIC 1500 may supply the power, for example, the power voltage, to each of the plurality of camera modules 1300a, 1300b, and 1300c. For example, the PMIC 1500 may supply the first power to the camera module 1300a via a power signal line PSLa, the second power to the camera module 1300b via a power signal line PSLb, and the third power to the camera module 1300c via a power signal line PSLc, under the control of the application processor 1400.

The PMIC 1500 may generate the power corresponding to each of the plurality of camera modules 1300a, 1300b, and 1300c and may adjust the power level, in response to a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the low-power mode and set power level. The levels of the power provided to the plurality of camera modules 1300a, 1300b, and 1300c may be equal to or different from each other. Also, the power level may be dynamically changed.

The above-described embodiments are summarized as follows.
(1) An image sensor according to an embodiment includes a sensor substrate including a plurality of unit pixel groups, each of the plurality of unit pixel groups including a first pixel, a second pixel, a third pixel, and a fourth pixel, and a nano-photonic lens array including a plurality of unit meta-groups, each of the plurality of unit meta-groups including a first meta-region corresponding to the first pixel, a second meta-region corresponding to the second pixel, a third meta-region corresponding to the third pixel, and a fourth meta-region corresponding to the fourth pixel,wherein each of the first to fourth meta-regions includes at least one nano-structure configured to condense, from among the light incident on the nano-photonic lens array, light of a first wavelength onto the first pixel and the fourth pixel, light of a second wavelength different from the first wavelength onto the second pixel, and light of a third wavelength different from the first and second wavelengths onto the third pixel, and at least one nano-structure provided in at least one of the second meta-region and the third meta-region is a polarization-separating nano-structure configured to provide the light of the first wavelength having a first polarization component to the first pixel and provide the light of the first wavelength having a second polarization component in a different direction from the first polarization component to the fourth pixel.
(2) The polarization-separating nano-structure may include a first extension portion extending in a first direction and a second extension portion extending in a second direction crossing the first direction, the first extension portion may have a first length in the first direction and a first width in the second direction and the second extension portion has a second length in the second direction and a second width in the first direction, and the first length may be greater than the first width and the second length may be greater than the second width.
(3) The first length and the second length may be equal to each other and the first width and the second width are equal to each other.
(4) The polarization-separating nano-structure may be configured so that the first extension portion and the second extension portion cross each other at centers thereof.
(5) The first extension portion and the second extension portion extend integrally with each other at a contact cross point.
(6) The second meta-region may include a first polarization-separating nano-structure configured to transmit, in light incident on the second meta-region, the light of the first wavelength having the first polarization component to the first pixel in the first direction and the light of the first wavelength having the second polarization component to the fourth pixel in the second direction, and the third meta-region may include a second polarization-separating nano-structure configured to transmit, in light incident on the third meta-region, the light of the first wavelength having the first polarization component to the first pixel in the second direction and the light of the first wavelength having the second polarization component to the fourth pixel in the first direction.
(7) The first polarization-separating nano-structure and the second polarization-separating nano-structure may be different from each other in at least one of the first length of the first extension portion, the first width of the first extension portion, the second length of the second extension portion, and the second width of the second extension portion.
(8) The first length of the first extension portion and the second length of the second extension portion may be less than a size of the second meta-region or the third meta-region in which the polarization-separating nano-structure is provided.
(9) The first length of the first extension portion may be equal to a width of the second meta-region or the third meta-region, in which the polarization-separating nano-structure is provided, in the first direction, or the second length of the second extension portion may be equal to a width of the second meta-region or the third meta-region, in which the polarization-separating nano-structure is provided, in the second direction.
(10) The second meta-region or the third meta-region may further include a plurality of polarization-separating sub-nano-structures that are symmetrically provided around the polarization-separating nano-structure, and each of the plurality of polarization-separating sub-nano structures may have a shape in which one end of the first extension portion in the first direction and one end of the second extension portion in the second direction are integrally connected at an angle of 90-degree.
(11) The polarization-separating nano-structure may include a plurality of first extension portions extending in a first direction and a plurality of second extension portions extending in a second direction crossing the first direction, each of the plurality of first extension portions may have a first length in the first direction and a first width in the second direction and each of the plurality of second extension portions may have a second length in the second direction and a second width in the first direction, and the first length may be greater than the first width and the second length is greater than the second width.
(12) The plurality of first extension portions may be spaced apart from one another and arranged in a row in the first direction, and the plurality of second extension portions may be spaced apart from one another and arranged in a row in the second direction.
(13) The polarization-separating nano-structure may include two first extension portions and two second extension portions, end portions facing each other in the two first extension portions may be spaced apart a same distance from the center of the second meta-region or the third meta-region, in which the polarization-separating nano-structure is provided, in the first direction, and end portions facing each other in the two second extension portions may be spaced apart a same distance from the center of the second meta-region or the third meta-region, in which the polarization-separating nano-structure is provided, in the second direction.
(14) The plurality of first extension portions and the plurality of second extension portions may be arranged so that a line segment in the first direction for connecting centers of the plurality of first extension portions and a line segment in the second direction for connecting centers of the plurality of second extension portions may cross each other at the center of the second meta-region or the third meta-region, in which the polarization-separating nano-structure is provided.
(15) Each of the plurality of first extension portions and each of the plurality of second extension portions may have rectangular shapes.
(16) The image sensor may further include a polarization-separating layer provided between the sensor substrate and the nano-photonic lens array, wherein the polarization-separating layer may include a plurality of unit polarization-separating groups each including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region, the first polarization-separating region may include a first polarizer that transmits the light of the first polarization component and reflects or absorbs the light of the second polarization component, and the fourth polarization-separating region may include a second polarizer that transmits the light of the second polarization component and reflects or absorbs the light of the first polarization component, and the second polarization-separating region and the third polarization-separating region may be filled with a material having transmittance with respect to visible light.
(17) The first pixel, the second pixel, the third pixel, and the fourth pixel may each include a first sub-pixel, a second sub-pixel, a third sub-pixel, and a fourth sub-pixel that are grouped and arranged two-dimensionally.
(18) The image sensor may include a polarization-separating layer provided between the sensor substrate and the nano-photonic lens array, wherein the polarization-separating layer may include a plurality of unit polarization-separating groups each including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region, the first polarization-separating region may include a first polarizer that transmits the light of the first polarization component and reflects or absorbs the light of the second polarization component, and the fourth polarization-separating region includes a second polarizer that transmits the light of the second polarization component and reflects or absorbs the light of the first polarization component, and the second polarization-separating region and the third polarization-separating region may each include the first polarizer, the second polarizer, a third polarizer transmitting light having a third polarization component that is in a different direction from the first polarization component and the second polarization component, and a fourth polarizer transmitting light having a fourth polarization component that is in a different direction from the first to third polarization components, the first polarizer, the second polarizer, the third polarizer, and the fourth polarizer of the second polarization-separating region may be each provided to face one of the first to fourth sub-pixels of the second pixel, and the first polarizer, the second polarizer, the third polarizer, and the fourth polarizer of the third polarization-separating region may be each provided to face one of the first to fourth sub-pixels of the third pixel.
(19) The image sensor may further include a polarization-separating layer provided between the sensor substrate and the nano-photonic lens array, wherein the polarization-separating layer may include a plurality of unit polarization-separating groups each including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region, the first polarization-separating region may include two first polarizers transmitting the light of the first polarization component and reflecting or absorbing the light of the second polarization component, the fourth polarization-separating region may include two second polarizers transmitting the light of the second polarization component and reflecting or absorbing the light of the first polarization component, the first polarization-separating region may further include two third polarizers transmitting light having a third polarization component that is in a different direction from the first polarization component and the second polarization component, the fourth polarization-separating region may further include two fourth polarizers transmitting light having a fourth polarization component that is in a different direction from the first to third polarization components, the second polarization-separating region and the third polarization-separating region may each include the first polarizer, the second polarizer, the third polarizer, and the fourth polarizer, the first polarizer, the second polarizer, the third polarizer, and the fourth polarizer of the second polarization-separating region may be each provided to face one of the first to fourth sub-pixels of the second pixel, and the first polarizer, the second polarizer, the third polarizer, and the fourth polarizer of the third polarization-separating region may be each provided to face one of the first to fourth sub-pixels of the third pixel.
(20) An electronic device according to an embodiment includes a lens assembly configured to form an optical image of a subject, an image sensor configured to convert the optical image formed by the lens assembly into an electrical signal, and a processor configured to process the electrical signal generated by the image sensor, wherein the image sensor includes a sensor substrate including a plurality of unit pixel groups, each of the plurality of unit pixel groups including a first pixel, a second pixel, a third pixel, and a fourth pixel, and a nano-photonic lens array including a plurality of unit meta-groups, each of the plurality of unit meta-groups including a first meta-region corresponding to the first pixel, a second meta-region corresponding to the second pixel, a third meta-region corresponding to the third pixel, and a fourth meta-region corresponding to the fourth pixel, wherein each of the first to fourth meta-regions includes at least one nano-structure configured to condense, from among the light incident on the nano-photonic lens array, light of a first wavelength onto the first pixel and the fourth pixel, light of a second wavelength different from the first wavelength onto the second pixel, and light of a third wavelength different from the first and second wavelengths onto the third pixel, and at least one nano-structure provided in at least one of the second meta-region and the third meta-region is a polarization-separating nano-structure configured to provide the light of the first wavelength having a first polarization component to the first pixel and provide the light of the first wavelength having a second polarization component in a different direction from the first polarization component to the fourth pixel.

While the image sensor including the nano-photonic lens array and the electronic apparats including the image sensor have been particularly shown and described with reference to exemplary embodiments thereof, it will be understood by those of ordinary skill in the art that various changes in form and details may be made therein without departing from the scope as defined by the following claims. The preferred embodiments should be considered in descriptive sense only and not for purposes of limitation. Therefore, the scope of the disclosure is defined not by the detailed description of the disclosure but by the appended claims, and all differences within the scope will be construed as being included in the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a sensor substrate including a plurality of unit pixel groups, each of the plurality of unit pixel groups including a first pixel, a second pixel, a third pixel, and a fourth pixel; and
a nano-photonic lens array including a plurality of unit meta-groups, each of the plurality of unit meta-groups including a first meta-region corresponding to the first pixel, a second meta-region corresponding to the second pixel, a third meta-region corresponding to the third pixel, and a fourth meta-region corresponding to the fourth pixel,
wherein each of the first to fourth meta-regions includes at least one nano-structure configured to condense, from among incident light on the nano-photonic lens array, light of a first wavelength onto the first pixel and the fourth pixel, light of a second wavelength different from the first wavelength onto the second pixel, and light of a third wavelength different from the first and second wavelengths onto the third pixel, and
at least one nano-structure provided in at least one of the second meta-region and the third meta-region is a polarization-separating nano-structure configured to provide the light of the first wavelength having a first polarization component to the first pixel and provide the light of the first wavelength having a second polarization component to the fourth pixel.

2. The image sensor of claim 1, wherein
the polarization-separating nano-structure includes a first extension portion extending in a first direction and a second extension portion extending in a second direction crossing the first direction,
the first extension portion has a first length in the first direction and a first width in the second direction and the second extension portion has a second length in the second direction and a second width in the first direction, and
the first length is greater than the first width and the second length is greater than the second width, and optionally wherein the first length is equal to the second length and the first width is equal to the second width.

3. The image sensor of claim 2, wherein the polarization-separating nano-structure is configured so that the first extension portion and the second extension portion cross each other at centers thereof, and optionally wherein the first extension portion and the second extension portion extend integrally with each other at a contact cross point.

4. The image sensor of claim 2 or 3, wherein
the second meta-region includes a first polarization-separating nano-structure configured to transmit, from among light incident on the second meta-region, the light of the first wavelength having the first polarization component to the first pixel in the first direction and the light of the first wavelength having the second polarization component to the fourth pixel in the second direction, and
the third meta-region includes a second polarization-separating nano-structure configured to transmit, from among light incident on the third meta-region, the light of the first wavelength having the first polarization component to the first pixel in the second direction and the light of the first wavelength having the second polarization component to the fourth pixel in the first direction, and optionally wherein the first polarization-separating nano-structure is different from the second polarization-separating nano-structure in at least one of the first length of the first extension portion, the first width of the first extension portion, the second length of the second extension portion, and the second width of the second extension portion.

5. The image sensor of claim 2, 3 or 4, wherein the first length of the first extension portion and the second length of the second extension portion are less than a size of the second meta-region or the third meta-region in which the polarization-separating nano-structure is provided.

6. The image sensor of claim 2, 3 or 4, wherein the first length of the first extension portion is equal to a width of the second meta-region or the third meta-region, in which the polarization-separating nano-structure is provided, in the first direction, or the second length of the second extension portion is equal to a width of the second meta-region or the third meta-region, in which the polarization-separating nano-structure is provided, in the second direction.

7. The image sensor of any of claims 2 to 6, wherein
the second meta-region or the third meta-region further includes a plurality of polarization-separating sub-nano-structures that are symmetrically provided around the polarization-separating nano-structure, and
each of the plurality of polarization-separating sub-nano structures has a shape in which one end of the first extension portion in the first direction and one end of the second extension portion in the second direction are integrally connected to each other at an angle of 90-degree.

8. The image sensor of any preceding claim, wherein
the polarization-separating nano-structure includes a plurality of first extension portions extending in a first direction and a plurality of second extension portions extending in a second direction crossing the first direction,
each of the plurality of first extension portions has a first length in the first direction and a first width in the second direction and each of the plurality of second extension portions has a second length in the second direction and a second width in the first direction, and
the first length is greater than the first width and the second length is greater than the second width, and optionally wherein the plurality of first extension portions are spaced apart from one another and arranged in a row in the first direction, and the plurality of second extension portions are spaced apart from one another and arranged in a row in the second direction, and further optionally wherein:
the polarization-separating nano-structure includes two first extension portions and two second extension portions;
end portions facing each other in the two first extension portions are spaced apart a same distance from a center of the second meta-region or the third meta-region, in which the polarization-separating nano-structure is provided, in the first direction; and
end portions facing each other in the two second extension portions are spaced apart a same distance from the center of the second meta-region or the third meta-region, in which the polarization-separating nano-structure is provided, in the second direction.

9. The image sensor of claim 8, wherein the plurality of first extension portions and the plurality of second extension portions are arranged so that a first line segment in the first direction for connecting centers of the plurality of first extension portions and a second line segment in the second direction for connecting centers of the plurality of second extension portions cross each other at a center of the second meta-region or the third meta-region, in which the polarization-separating nano-structure is provided.

10. The image sensor of claim 8 or 9, wherein each of the plurality of first extension portions and each of the plurality of second extension portions have rectangular shapes.

11. The image sensor of any preceding claim, further comprising
a polarization-separating layer provided between the sensor substrate and the nano-photonic lens array,
wherein the polarization-separating layer includes a plurality of unit polarization-separating groups, each of the plurality of unit polarization-separating groups including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region,
the first polarization-separating region includes a first polarizer configured to transmit the light of the first polarization component and reflects or absorbs the light of the second polarization component, and the fourth polarization-separating region includes a second polarizer configured to transmit the light of the second polarization component and reflects or absorbs the light of the first polarization component, and
the second polarization-separating region and the third polarization-separating region are filled with a material having transmittance with respect to visible light.

12. The image sensor of any preceding claim, wherein the first pixel, the second pixel, the third pixel, and the fourth pixel each include a first sub-pixel, a second sub-pixel, a third sub-pixel, and a fourth sub-pixel that are grouped and arranged two-dimensionally.

13. The image sensor of claim 12, further comprising
a polarization-separating layer provided between the sensor substrate and the nano-photonic lens array,
wherein the polarization-separating layer includes a plurality of unit polarization-separating groups, each of the plurality of unit polarization-separating groups including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region,
the first polarization-separating region includes a first polarizer configured to transmit the light of the first polarization component and reflects or absorbs the light of the second polarization component, and the fourth polarization-separating region includes a second polarizer configured to transmit the light of the second polarization component, and reflect or absorb the light of the first polarization component, and
the second polarization-separating region and the third polarization-separating region each includes the first polarizer, the second polarizer, a third polarizer configured to transmit light having a third polarization component that is in a different direction from the first polarization component and the second polarization component, and a fourth polarizer configured to transmit light having a fourth polarization component that is in a different direction from the first to third polarization components,
the first polarizer, the second polarizer, the third polarizer, and the fourth polarizer of the second polarization-separating region are each provided to face one of the first to fourth sub-pixels of the second pixel, and
the first polarizer, the second polarizer, the third polarizer, and the fourth polarizer of the third polarization-separating region are each provided to face one of the first to fourth sub-pixels of the third pixel.

14. The image sensor of claim 12, further comprising
a polarization-separating layer provided between the sensor substrate and the nano-photonic lens array,
wherein the polarization-separating layer includes a plurality of unit polarization-separating groups, each of the plurality of unit polarization-separating groups including a first polarization-separating region corresponding to the first pixel and the first meta-region, a second polarization-separating region corresponding to the second pixel and the second meta-region, a third polarization-separating region corresponding to the third pixel and the third meta-region, and a fourth polarization-separating region corresponding to the fourth pixel and the fourth meta-region,
the first polarization-separating region includes two first polarizers configured to transmit the light of the first polarization component, and reflect or absorb the light of the second polarization component,
the fourth polarization-separating region includes two second polarizers configured to transmit the light of the second polarization component, and reflect or absorb the light of the first polarization component,
the first polarization-separating region further includes two third polarizers configured to transmit light having a third polarization component that is in a different direction from the first polarization component and the second polarization component,
the fourth polarization-separating region further includes two fourth polarizers configured to transmit light having a fourth polarization component that is in a different direction from the first to third polarization components,
the second polarization-separating region and the third polarization-separating region each include the first polarizer, the second polarizer, the third polarizer, and the fourth polarizer,
the first polarizer, the second polarizer, the third polarizer, and the fourth polarizer of the second polarization-separating region are each provided to face one of the first to fourth sub-pixels of the second pixel, and
the first polarizer, the second polarizer, the third polarizer, and the fourth polarizer of the third polarization-separating region are each provided to face one of the first to fourth sub-pixels of the third pixel.

15. An electronic device comprising:
a lens assembly configured to form an optical image of a subject;
an image sensor according to any preceding claim configured to convert the optical image into an electrical signal; and
a processor configured to process the electrical signal.
